# EUROPEAN PATENT APPLICATION

(11) **EP 4 546 969 A1**
(43) Date of publication of application: **30.04.2025**
(21) Application number: 24208835.9
(22) Date of filing: 25.10.2024
(51) Int. Cl.: H10B 12/00

(54) **SEMICONDUCTOR DEVICE AND METHOD FOR MANUFACTURING THE SAME**

(30) Priority: 27.10.2023 KR 20230146104
(71) Applicant: SK hynix Inc., Bubal-eub Icheon-si Gyeonggi-do 17336 (KR)
(72) Inventor: SUNG, Min Chul, 17336 Icheon-si (KR); KIM, Seiyon, 17336 Icheon-si (KR); RYU, Seung Wook, 17336 Icheon-si (KR)
(74) Representative: Isarpatent

(57) **Abstract**

A semiconductor device includes a bit line extending in a first direction; a first gate extending in a second direction perpendicular to the first direction; an active region including a horizontal portion that contacts the bit line and a vertical portion that contacts the horizontal portion and extends in a third direction perpendicular to each of the first direction and the second direction; and a second gate overlapping with at least a portion of the horizontal portion while extending in the second direction, wherein the vertical portion of the active region is disposed between the first gate and the second gate.

## Description

The technology and embodiments disclosed in the present disclosure generally relate to a semiconductor device, and more particularly to a semiconductor device including memory cells.

### BACKGROUND

As miniaturization and a higher degree of integration of semiconductor devices have become major issues, memory cells included in semiconductor devices may be formed to have three-dimensional (3D) patterns. Miniaturized memory cells with three-dimensional (3D) patterns may be equipped with configurations that improve operation characteristics of the memory cells.

### SUMMARY

Various embodiments of the present disclosure relate to a semiconductor memory device with a higher degree of integration.

Various embodiments of the present disclosure relate to a semiconductor memory device that prevents signal interference between word lines.

In accordance with an embodiment of the present disclosure, a semiconductor device may include a bit line extending in a first direction; a first gate extending in a second direction perpendicular to the first direction; an active region including a horizontal portion that contacts the bit line and a vertical portion that contacts the horizontal portion and extends in a third direction perpendicular to each of the first direction and the second direction; and a second gate overlapping with at least a portion of the horizontal portion while extending in the second direction, wherein the vertical portion of the active region is disposed between the first gate and the second gate.

In some embodiments, the first gate may not overlap with horizontal portion.

In some embodiments, the semiconductor device may further include a contact pad in contact with the vertical portion of the active region and spaced apart from the horizontal portion in the third direction.

In some embodiments, the contact pad may connect a capacitive element and vertical portion of the active region to each other.

In some embodiments, the contact pad may have a larger width than the vertical portion of the active region.

In some embodiments, the capacitive element may be a capacitor.

In some embodiments, the contact pad may include a plurality of layers, wherein a layer contacting the vertical portion from among the plurality of layers includes an oxide semiconductor material.

In some embodiments, the contact pad may include a plurality of layers, wherein a layer contacting the capacitive element from among the plurality of layers includes metal or metal nitride.

In some embodiments, the active region may include an oxide semiconductor material.

In some embodiments, the oxide semiconductor material may include indium gallium zinc oxide (IGZO).

In some embodiments, the first gate may be configured to receive a control signal different from that of the second gate.

In some embodiments, one first gate may be disposed between the active region and another active region adjacent to the active region.

In some embodiments, the first gate may be configured to receive the same control signal as the second gate.

In some embodiments, one pair of the first gates may be disposed between the active region and another active region adjacent to the active region.

In some embodiments, the second gate may include at least one contact portion connected to a conductive line.

In some embodiments, the contact portions may be arranged in a zigzag pattern with respect to the first direction and may be spaced apart from each other by a predetermined distance.

In accordance with another embodiment of the present disclosure, a semiconductor device may include a bit line extending in a first direction; a first gate extending in a second direction perpendicular to the first direction; a second gate extending in the second direction while facing or opposite to the first gate; and an active region including a vertical portion that is disposed between the first gate and the second gate and extends in a third direction perpendicular to each of the first direction and the second direction, and a horizontal portion that contacts the bit line and extends in the first direction, wherein the first gate is disposed between the vertical portions respectively included in different active regions adjacent to each other.

In some other embodiments, the first gate may not overlap with the horizontal portion; and the second gate may overlap with the horizontal portion.

In some other embodiments, the semiconductor device may further include a contact pad in contact with the vertical portion of the active region and spaced apart from the horizontal portion in the third direction.

In some other embodiments, the contact pad may connect a capacitive element and vertical portion of the active region to each other.

In some other embodiments, the contact pad may include a plurality of layers, wherein a layer contacting the vertical portion from among the plurality of layers includes an oxide semiconductor material; and a layer contacting the capacitive element from among the plurality of layers includes metal or metal nitride.

It is to be understood that both the foregoing general description and the following detailed description of the embodiments of the present disclosure are illustrative and descriptive and are intended to provide further description of the embodiments of the present disclosure as claimed.

### BRIEF DESCRIPTION OF THE DRAWINGS

The above and other features and beneficial aspects of the present disclosure will become readily apparent with reference to the following detailed description when considered in conjunction with the accompanying drawings.
FIG. 1A is a schematic perspective view illustrating a semiconductor device according to an embodiment of the present disclosure.
FIG. 1B is a schematic perspective view illustrating a semiconductor device according to another embodiment of the present disclosure.
FIG. 2A is a schematic diagram illustrating a layout structure of the semiconductor device according to an embodiment of the present disclosure.
FIG. 2B is a cross-sectional view illustrating the semiconductor device taken along the line A1-A1' shown in FIG. 2A. FIG. 2C is a cross-sectional view illustrating the semiconductor device taken along the line A2-A2' shown in FIG. 2A. FIG. 2D is a cross-sectional view illustrating the semiconductor device taken along the line A3-A3' shown in FIG. 2A.
FIG. 2E is a schematic diagram illustrating a layout structure of the semiconductor device according to another embodiment of the present disclosure.
FIG. 3A is a schematic diagram illustrating a semiconductor device according to another embodiment of the present disclosure.
FIG. 3B is a cross-sectional view illustrating the semiconductor device taken along the line B1-B1' shown in FIG. 3A. FIG. 3C is a cross-sectional view illustrating the semiconductor device taken along the line B2-B2' shown in FIG. 3A. FIG. 3D is a cross-sectional view illustrating the semiconductor device taken along the line B3-B3' shown in FIG. 3A.
FIG. 3E is a schematic diagram illustrating a layout structure of the semiconductor device according to another embodiment of the present disclosure.
FIG. 4A is a cross-sectional view illustrating a method for manufacturing a semiconductor device in which bit lines are formed over a first oxide layer according to an embodiment of the present disclosure.
FIG. 4B is a cross-sectional view illustrating the semiconductor device taken along the line C1-C1' shown in FIG. 4A, and FIG. 4C is a cross-sectional view illustrating the semiconductor device taken along the line C2-C2' shown in FIG. 4A.
FIG. 5A is a perspective view illustrating a method for manufacturing a semiconductor device in which a first gate is formed over a first bit-line isolation layer, a second bit-line isolation layer, and a third bit-line isolation layer according to an embodiment of the present disclosure.
FIG. 5B is a cross-sectional view illustrating the semiconductor device taken along the line D1-D1' shown in FIG. 5A, and FIG. 5C is a cross-sectional view illustrating the semiconductor device taken along the line D2-D2' shown in FIG. 5A.
FIG. 6A is a perspective view illustrating a method for manufacturing a semiconductor device in which a first gate oxide layer and a protective silicon layer are formed over the first gate according to an embodiment of the present disclosure.
FIG. 6B is a cross-sectional view illustrating the semiconductor device taken along the line E1-E1' shown in FIG. 6A, and FIG. 6C is a cross-sectional view illustrating the semiconductor device taken along the line E2-E2' shown in FIG. 6A.
FIG. 7A is a perspective view illustrating a method for manufacturing a semiconductor device in which at least a portion of a protective silicon layer, at least a portion of a first gate oxide layer, and at least a portion of a first bit-line isolation layer are etched according to an embodiment of the present disclosure.
FIG. 7B is a cross-sectional view illustrating the semiconductor device taken along the line F1-F1' shown in FIG. 7A, and FIG. 7C is a cross-sectional view illustrating the semiconductor device taken along the line F2-F2' shown in FIG. 7A.
FIG. 8A is a perspective view illustrating a method for manufacturing a semiconductor device in which a pre-active region layer is formed over a first gate and a bit line according to an embodiment of the present disclosure.
FIG. 8B is a cross-sectional view illustrating the semiconductor device taken along the line G1-G1' shown in FIG. 8A, and FIG. 8C is a cross-sectional view illustrating the semiconductor device taken along the line G2-G2' shown in FIG. 8A.
FIG. 9A is a perspective view illustrating a method for manufacturing a semiconductor device in which an active region is selectively formed over a first gate and a bit line according to an embodiment of the present disclosure.
FIG. 9B is a cross-sectional view illustrating the semiconductor device taken along the line H1-H1' shown in FIG. 9A, and FIG. 9C is a cross-sectional view illustrating the semiconductor device taken along the line H2-H2' shown in FIG. 9A.
FIG. 10A is a perspective view illustrating a method for manufacturing a semiconductor device in which a second gate oxide layer, a pre-second gate layer, and a contact mask are formed according to an embodiment of the present disclosure.
FIG. 10B is a cross-sectional view illustrating the semiconductor device taken along the line I1-I1' shown in FIG. 10A, FIG. 10C is a cross-sectional view illustrating the semiconductor device taken along the line I2-I2' shown in FIG. 10A, and FIG. 10D is a cross-sectional view illustrating the semiconductor device taken along the line I3-I3' shown in FIG. 10A.
FIG. 11A is a perspective view illustrating a method for manufacturing a semiconductor device in which a second gate layer and a contact portion are formed according to an embodiment of the present disclosure.
FIG. 11B is a cross-sectional view illustrating the semiconductor device taken along the line J1-J1' shown in FIG. 11A, FIG. 11C is a cross-sectional view illustrating the semiconductor device taken along the line J2-J2' shown in FIG. 11A, and FIG. 11D is a cross-sectional view illustrating the semiconductor device taken along the line J3-J3' shown in FIG. 11A.
FIG. 12A is a perspective view illustrating a method for manufacturing a semiconductor device in which a third nitride layer and a second oxide layer are formed according to an embodiment of the present disclosure.
FIG. 12B is a cross-sectional view illustrating the semiconductor device taken along the line K1-K1' shown in FIG. 12A, FIG. 12C is a cross-sectional view illustrating the semiconductor device taken along the line K2-K2' shown in FIG. 12A, and FIG. 12D is a cross-sectional view illustrating the semiconductor device taken along the line K3-K3' shown in FIG. 12A.
FIG. 13 is a perspective view illustrating a method for manufacturing a semiconductor device in which a portion of the second oxide layer is etched according to an embodiment of the present disclosure.
FIG. 14 is a perspective view illustrating a method for manufacturing a semiconductor device in which a mask is formed over the etched second oxide layer according to an embodiment of the present disclosure.
FIG. 15 is a perspective view illustrating a method for manufacturing a semiconductor device in which a mask is removed after selectively etching both ends of the second gate according to an embodiment of the present disclosure.
FIG. 16A is a perspective view illustrating a method for manufacturing a semiconductor device in which adjacent active regions are isolated from each other in a first direction (D1) according to an embodiment of the present disclosure.
FIG. 16B is a cross-sectional view illustrating the semiconductor device taken along the line L1-L1' shown in FIG. 16A, FIG. 16C is a cross-sectional view illustrating the semiconductor device taken along the line L2-L2' shown in FIG. 16A, and FIG. 16D is a cross-sectional view illustrating the semiconductor device taken along the line L3-L3' shown in FIG. 16A.
FIG. 17A is a perspective view illustrating a method for manufacturing a semiconductor device in which a contact pad contacting one end of a vertical portion included in an active region is formed according to an embodiment of the present disclosure.
FIG. 17B is a cross-sectional view illustrating the semiconductor device taken along the line M1-M1' shown in FIG. 17A, and FIG. 17C is a cross-sectional view illustrating the semiconductor device taken along the line M2-M2' shown in FIG. 17A.
FIG. 17D is a cross-sectional view illustrating the semiconductor taken along the line M1-M1' shown in FIG. 17A after etching a second hard mask layer, and FIG. 17E is a cross-sectional view illustrating the semiconductor device taken along the line M2-M2' shown in FIG. 17A after etching the second hard mask layer.
FIG. 18A is a perspective view illustrating a method for manufacturing a semiconductor device in which a contact pad contacting one end of a vertical portion included in an active region is formed according to an embodiment of the present disclosure.
FIG. 18B is a cross-sectional view illustrating a semiconductor device taken along the line N1-N1' shown in FIG. 18A, and FIG. 18C is a cross-sectional view illustrating a semiconductor device taken along the line N2-N2' shown in FIG. 18A.
FIG. 19A is a perspective view illustrating a method for manufacturing a semiconductor device in which a contact pad contacting one end of a vertical portion included in an active region is formed according to an embodiment of the present disclosure.
FIG. 19B is a cross-sectional view illustrating a semiconductor device taken along the line O1-O1' shown in FIG. 19A, and FIG. 19C is a cross-sectional view illustrating a semiconductor device taken along the line O2-O2' shown in FIG. 19A.
FIG. 20A is a perspective view illustrating a method for manufacturing a semiconductor device in which an isolation oxide layer is formed over a first bit-line isolation layer, a second bit-line isolation layer, and a third bit-line isolation layer according to an embodiment of the present disclosure.
FIG. 20B is a cross-sectional view illustrating a semiconductor device taken along the line P1-P1' shown in FIG. 20A, and FIG. 20C is a cross-sectional view illustrating a semiconductor device taken along the line P2-P2' shown in FIG. 20A.
FIG. 21A is a perspective view illustrating a method for manufacturing a semiconductor device in which a pre-first gate layer is formed over an isolation oxide layer according to an embodiment of the present disclosure.
FIG. 21B is a cross-sectional view illustrating a semiconductor device taken along the line Q1-Q1' shown in FIG. 21A, and FIG. 21C is a cross-sectional view illustrating a semiconductor device taken along the line Q2-Q2' shown in FIG. 21A.
FIG. 22A is a perspective view illustrating a method for manufacturing a semiconductor device in which a first gate is formed by etching a pre-first gate layer and a first gate oxide layer is formed over the first gate according to an embodiment of the present disclosure.
FIG. 22B is a cross-sectional view illustrating a semiconductor device taken along the line R1-R1' shown in FIG. 22A, and FIG. 22C is a cross-sectional view illustrating a semiconductor device taken along the line R2-R2' shown in FIG. 22A.
FIG. 23A is a perspective view illustrating a method for manufacturing a semiconductor device in which a protective silicon layer is formed over a first gate oxide layer according to an embodiment of the present disclosure.
FIG. 23B is a cross-sectional view illustrating a semiconductor device taken along the line S1-S1' shown in FIG. 23A, and FIG. 23C is a cross-sectional view illustrating a semiconductor device taken along the line S2-S2' shown in FIG. 23A.
FIG. 24A is a perspective view illustrating a method for manufacturing a semiconductor device in which at least a portion of a protective silicon layer, at least a portion of a first gate oxide layer, and at least a portion of a first bit-line isolation layer are etched according to an embodiment of the present disclosure.
FIG. 24B is a cross-sectional view illustrating a semiconductor device taken along the line T1-T1' shown in FIG. 24A, and FIG. 24C is a cross-sectional view illustrating a semiconductor device taken along the line T2-T2' shown in FIG. 24A.
FIG. 25A is a perspective view illustrating a method for manufacturing a semiconductor device in which a pre-active region layer is formed over a first gate oxide layer and a bit line according to an embodiment of the present disclosure.
FIG. 25B is a cross-sectional view illustrating a semiconductor device taken along the line U1-U1' shown in FIG. 25A, and FIG. 25C is a cross-sectional view illustrating a semiconductor device taken along the line U2-U2' of FIG. 25A.

### DETAILED DESCRIPTION

The present disclosure provides embodiments and examples of a semiconductor device including memory cells that may be used in configurations to substantially address one or more technical or engineering issues and to mitigate limitations or disadvantages encountered in some other semiconductor devices. Some embodiments of the present disclosure relate to a semiconductor memory device with a higher degree of integration. Some embodiments of the present disclosure relate to a semiconductor memory device that prevents signal interference between word lines. In recognition of the issues above, the embodiments of the present disclosure may provide the semiconductor device that has three-dimensional (3D) channels to improve the degree of integration. The embodiments of the present disclosure may provide the semiconductor device including a plurality of gates, so that the degree of integration may be improved and interference between adjacent gates may be minimized.

Reference will now be made in detail to the embodiments of the present disclosure, examples of which are illustrated in the accompanying drawings. Wherever possible, the same reference numbers will be used throughout the drawings to refer to the same or like parts. While the embodiments of the present disclosure are susceptible to various modifications and alternative forms, specific embodiments thereof are shown by way of example in the drawings. However, the present disclosure should not be construed as being limited to the embodiments set forth herein.

Hereinafter, various embodiments will be described with reference to the accompanying drawings. However, it should be understood that the embodiments are not limited to specific embodiments, but include various modifications, equivalents and/or alternatives of the embodiments. The embodiments of the present disclosure may provide a variety of advantageous effects capable of being directly or indirectly recognized.

In the following description, a detailed description of related known configurations or functions incorporated herein will be omitted to avoid obscuring the subject matter.

The terminology used herein is for the purpose of describing particular embodiments only and is not intended to be limiting of the present disclosure. As used herein, the singular forms are intended to include the plural forms as well, unless the context clearly indicates otherwise. It will be further understood that the terms "comprises", "includes", "including", and/or "comprising," when used in this specification, specify the presence of stated constituent elements, steps, operations, and/or components, but do not preclude the presence or addition of one or more other constituent elements, steps, operations, and/or components thereof. The term "and/or" may include a combination of a plurality of items or one of a plurality of items.

Hereinafter, a semiconductor device and a method for manufacturing the same according to embodiments of the present disclosure will be described with reference to the attached drawings.

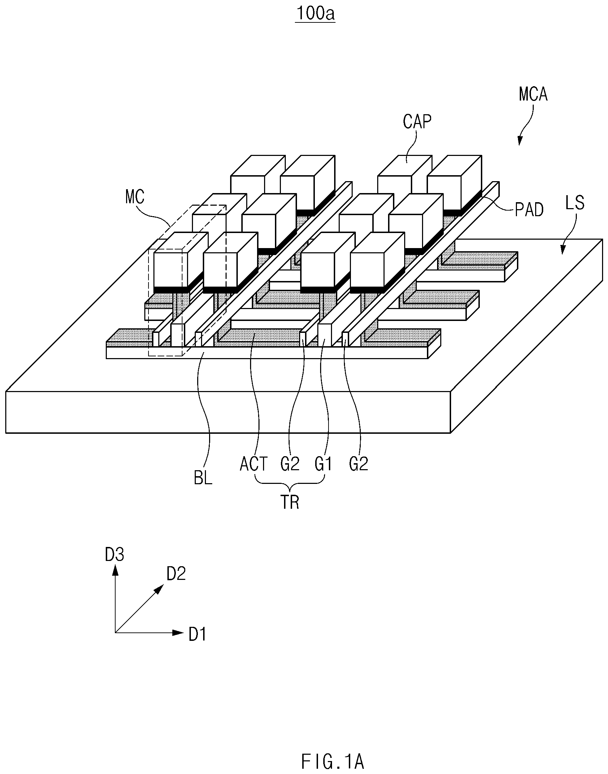

FIG. 1A is a schematic perspective view illustrating a semiconductor device 100a according to an embodiment of the present disclosure.

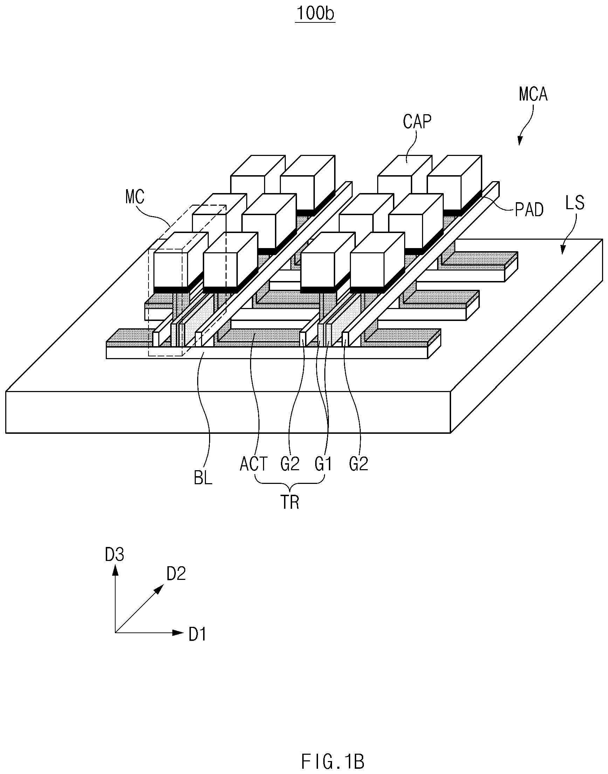

FIG. 1B is a schematic perspective view illustrating a semiconductor device 100b according to another embodiment of the present disclosure.

Referring to FIGS. 1A and 1B, each of the semiconductor devices (100a, 100b) may include a substrate (LS) and a memory cell array (MCA) formed over the substrate (LS). The memory cell array (MCA) may include a plurality of memory cells (MC) repeatedly arranged over the substrate (LS).

In some embodiments, each memory cell may have a three-dimensional (3D) structure.

More specifically, each of the memory cells (MC) included in the memory cell array (MCA) may include a bit line (BL), a transistor (TR), a contact pad (PAD), and a capacitor (CAP).

The bit line (BL) may be disposed over the substrate (LS), and may extend in a first direction (D1) parallel to one surface of the substrate (LS). Adjacent bit lines (BL) may be isolated from each other by an insulation layer (not shown).

The insulation layer may include, for example, silicon oxide, silicon nitride, metal oxide, metal oxynitride, metal silicate, high-k material, ferroelectric material, anti-ferroelectric material, or a combination thereof. In some other embodiments, the insulation layer may include SiO₂, Si₃N₄, HfO₂, Al₂O₃, ZrO₂, AION, HfON, HfSiO, HfSiON, and the like. In some other embodiments, the insulation layer may include SiCO and the like.

In some embodiments, the capacitors (CAP) may be spaced apart from the bit line (BL) in a third direction (D3), and may be arranged in a matrix structure.

In some other embodiments, the capacitors (CAP) may be arranged obliquely with respect to a region in which the gates (G1, G2) and the bit line (BL) overlap each other. More specifically, the capacitors (CAP) may be arranged to deviate from the center of the contact pad (PAD) that contacts one side of an active region (ACT), and may be arranged either in a zigzag shape or in a honeycomb shape with respect to the contact pads (PAD) arranged in a matrix structure.

The transistor (TR) may be disposed between the bit line (BL) and the capacitor (CAP) in the third direction (D3).

The transistor (TR) may include at least a portion of the active region (ACT) connected to the bit line (BL), a first gate (G1) and a second gate (G2).

According to the embodiment of FIG. 1A, a word line driving voltage may be provided to the second gate (G2) extending in the second direction (D2). The second gate (G2) may operate as a word line of the transistor (TR).

At this time, the first gate (G1) extending opposite to the second gate (G2) may be provided with a voltage different from that of the second gate (G2) to prevent interference between the second gates (G2) of the adjacent transistors (TR). For example, a ground voltage may be provided to the first gate (G1). The first gate (G1) may operate as a back gate.

According to the embodiment of FIG. 1B, the same word line driving voltage may be provided to the first gate (G1) and the second gate (G2) adjacent to each other based on the active region (ACT) interposed therebetween. The first gate (G1) and the second gate (G2) may operate as a word line of the transistor (TR).A transistor (TR) in which the first gate (G1) and the second gate (G2) operate as the word line may hereinafter be referred to as a double gate transistor.

The first direction (D1) may be perpendicular to the second direction (D2), and the third direction (D3) may be perpendicular to each of the first direction (D1) and the second direction (D2).

Each memory cell (MC) may include a contact pad (PAD) that electrically connects the capacitor (CAP) and the bit line (BL) to each other. The contact pad (PAD) may contact one side of the vertical portion of the active region (ACT).

The active region (ACT) may include a channel region and source/drain regions of the transistor (TR). For example, the channel region may be formed in the active region (ACT) depending on the voltage applied to the gate (e.g., the first gate G1 or the second gate G2) of the transistor (TR), and electrons may move between the source/drain regions through the channel region.

The active region (ACT) may include a horizontal portion extending in the first direction (D1) and a vertical portion extending in the third direction (D3).

Each memory cell (MC) may include a single transistor (TR).

Two adjacent vertical portions included in the active region (ACT) may be connected to each other by one horizontal portion. The horizontal portion of the active region (ACT) may be connected to the bit line (BL). The horizontal portion of the active region (ACT) may be a layer formed on the bit line (BL). Additionally, the active region (ACT) may be electrically isolated from the gates (G1, G2) by an insulation layer (not shown).

The memory cell array (MCA) may include a DRAM cell array. In some other embodiments, the memory cell array (MCA) may include Phase Change Random Access Memory (PCRAM), Resistive Random Access Memory (ReRAM), Magnetic Random Access Memory (MRAM), and the like. The capacitor (CAP) may be replaced with another memory element as necessary.

The substrate (LS) may be a material suitable for semiconductor processing. The substrate (LS) may include at least one of a conductive material, an insulation material (also called a dielectric material), and a semiconductor material (also called a semiconductive material). In some embodiments, a plurality of material layers may be formed over the substrate (LS).

The substrate (LS) may include a semiconductor substrate. For example, the substrate (LS) may be formed of a semiconductor material containing silicon. The substrate (LS) may include silicon, monocrystalline silicon, amorphous silicon, silicon germanium, monocrystalline silicon germanium, polycrystalline silicon germanium, carbon-doped silicon, a combination thereof, or multilayers thereof. The substrate (LS) may also include other semiconductor materials such as germanium. The substrate (LS) may include a group III/V semiconductor substrate, for example, a compound semiconductor substrate such as gallium arsenide ("GaAs").

The substrate (LS) may include a silicon on insulator (SOI) substrate. In another embodiment, the substrate (LS) may include a peripheral circuit region (not shown) located at a lower portion thereof. The peripheral circuit region may include a plurality of control circuits for controlling the memory cell array (MCA). At least one control circuit of the peripheral circuit region may include an N-channel transistor, a P-channel transistor, a CMOS circuit, or a combination thereof. At least one control circuit of the peripheral circuit region may include an address decoder circuit, a read circuit, a write circuit, and the like.

At least one control circuit included in the peripheral circuit region may include a planar channel transistor, a recess channel transistor, a buried gate transistor, a fin channel transistor (FinFET), and the like.

At least one control circuit included in the peripheral circuit region may be electrically connected to the bit line (BL). The peripheral circuit region may include a sense amplifier (sense-amp), and the sense amplifier (sense-amp) may be electrically connected to the bit line (BL). Although not shown, a multi-level metal interconnection may be disposed between the substrate (LS) and the memory cell array (MCA). The peripheral circuit region and the bit line (BL) may be connected to each other through the multi-level metal interconnection.

The bit lines (BL) may be disposed over the substrate (LS), the insulation layer may be disposed between the bit lines (BL), and the bit lines (BL) may be laterally (or horizontally) oriented in the first direction (D1).

The bit lines (BL) may be referred to as a laterally-oriented bit line or a laterally-extended bit line.

The bit lines (BL) may include a conductive material. Each of the bit lines (BL) may include a silicon-based material, a metal-based material, or a combination thereof. Each of the bit lines (BL) may include polysilicon, metal, metal nitride, metal silicide, or a combination thereof.

The bit line (BL) may include polysilicon, titanium nitride, tungsten (W), or a combination thereof. For example, the bit line (BL) may include polysilicon doped with N-type impurities or titanium nitride (TiN).

The bit line (BL) may include a stacked structure (TiN/W) of titanium nitride (TiN) and tungsten (W). The bit line (BL) may further include an ohmic contact layer formed of, for example, a metal silicide.

Memory cells (MC) arranged horizontally in the first direction (D1) may share one bit line (BL). An insulation layer extending in the first direction (D1) may be provided between adjacent bit lines (BL). The insulation layer may include a plurality of layers and may function as a spacer to isolate adjacent bit lines (BL) from each other.

The transistors (TR) may be arranged in a matrix structure in the first direction (D1) and the second direction (D2).

Each transistor (TR) may be disposed between a corresponding one of the bit lines (BL) and a corresponding one of the capacitors (CAP).

Each transistor (TR) may include an active region (ACT), an insulation layer (not shown), and gates (G1, G2).

The gates (G1, G2) may extend in the second direction (D2), and the active region (ACT) may include a horizontal portion extending in the first direction (D1) and a vertical portion extending in the third direction (D3).

The insulation layer may be disposed to isolate adjacent active regions (ACT) and the gates (G1, G2) from each other.

Each of the gates (G1, G2) may include a metal, a metal mixture, a metal alloy, titanium nitride, tungsten, polysilicon, or a combination thereof.

For example, the gates (G1, G2) may include a stacked structure (TiN/W) in which titanium nitride and tungsten are sequentially stacked.

The gates (G1, G2) may extend in one direction, and the bit line (BL) may extend in the other direction perpendicular to the one direction. The active region (ACT) may include a semiconductor material or an oxide semiconductor material.

The bit line (BL) may be electrically isolated from the gates (G1, G2) by an insulation layer. The insulation layer may be disposed between the bit line (BL) and the gates (G1, G2).

The active region (ACT) may include a plurality of impurity regions. The impurity regions may include the source/drain regions of the transistor (TR).

The active region (ACT) may include doped polysilicon, undoped polysilicon, amorphous silicon, IGZO (amorphous indium gallium zinc oxide semiconductor), indium zinc oxide (IZO), indium tin oxide (ITO), indium oxide (InO₃), and the like.

The horizontal portion included in the active region (ACT) may be electrically connected to the bit line (BL). Additionally, a contact pad (PAD) may contact a vertical portion included in the active region (ACT), and the capacitor (CAP) and the active region (ACT) may be electrically connected to each other through the contact pad (PAD).

The active region (ACT) may be electrically isolated from the gates (G1, G2) by the insulation layer. The insulation layer may be disposed between the active region (ACT) and the gates (G1, G2) to prevent the active region (ACT) and the gates (G1, G2) from being electrically interconnected.

In addition, the insulation layer may be disposed between the gates (G1, G2), and the gates (G1, G2) may be electrically isolated from each other by the insulation layer.

The insulation layer may include, for example, silicon oxide, hafnium oxide, zirconium oxide, aluminum oxide, or the like. There may be a difference in composition between the insulation layers according to locations of the insulation layers. For example, the insulation layer disposed between the gates (G1, G2) may include silicon oxide, and the insulation layer disposed between the active region (ACT) and the gates (G1, G2) may include a high-k material.

The capacitor (CAP) may have a shape that extends vertically from one surface of the substrate (LS), and may be arranged to contact the vertical portion included in the active region (ACT). The capacitor (CAP) may include a metal-insulator-metal (MIM) structure.

The capacitor (CAP) may include two poles and a dielectric layer disposed between the two poles. The dielectric layer may include silicon oxide, silicon nitride, a high-k material (e.g., hafnium oxide or aluminum oxide), or a combination thereof.

The high-k material may have a higher dielectric constant than silicon oxide. Silicon oxide (SiO₂) may have a dielectric constant of about 3.9, and the dielectric layer may include a high-k material with a dielectric constant of 4 or more. For example, the high-k material may have a dielectric constant of about 20 or more.

The high-k material may include hafnium oxide (HfO₂), zirconium oxide (ZrOz), aluminum oxide (Al₂O₃), lanthanum oxide (LazOs), titanium oxide (TiO₂), tantalum oxide (Ta₂O₅), niobium oxide (Nb₂O₅), or strontium titanium oxide (SrTiO₃) and the like. In another embodiment, the dielectric layer may include a composite layer including two or more layers formed of the above-mentioned high-k material.

The dielectric layer may include a stacked structure of a high-k material and a high bandgap material that has a larger band gap than the high-k material. For example, the dielectric layer may include silicon oxide (SiO₂) as another high bandgap material in addition to aluminum oxide (Al₂O₃). Leakage current may be suppressed by the dielectric layer containing a high bandgap material.

The dielectric layer may include a laminated structure in which high-k materials and high bandgap materials are alternately stacked. For example, the laminated structure may include ZAZA (ZrO₂/AlO₃/ZrO₂/Al₂O₃), ZAZAZ (ZrO₂/Al₂O₃/ZrO₂/Al₂O₃/ZrO₂), HAHA (HfO₂/Al₂O₃/HfO₂/Al₂O₃) or HAHAH (HfO₂/Al₂O₃/HfO₂/Al₂O₃/HfO₂).

An anode included in the capacitor (CAP) may include a metal, a noble metal, a metal nitride, a conductive metal oxide, a conductive noble metal oxide, a metal carbide, a metal silicide, or a combination thereof. For example, the anode included in the capacitor (CAP) may include titanium (Ti), titanium nitride (TiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, and a tungsten nitride/tungsten (WN/W) stack.

In another embodiment, the poles of the capacitor (CAP) may include a combination of a metal-based material and a silicon-based material. For example, the combination of a metal-based material and a silicon-based material may be a stacked structure of titanium nitride/silicon germanium/tungsten nitride (TiN/SiGe/WN).

The capacitor (CAP) may have a three-dimensional (3D) structure, and the three-dimensional capacitors (CAP) may be repeatedly arranged in a matrix shape on one surface of the substrate (LS). The three-dimensional (3D) structure may be, for example, a cylindrical shape, a pillar shape, or a pillinder shape. Here, the pillinder shape may refer to a structure in which the pillar shape and the cylindrical shape are merged.

In another embodiment, the capacitor (CAP) may have a structure that is obliquely arranged with respect to a contact pad (PAD) located in a region in which the bit line (BL) and the gates (G1, G2) are arranged to overlap each other so that the largest number of capacitors (CAP) may be arranged in the same area.

The memory cells (MC) may share the first and second gates (G1) and (G2). The first and second gates (G1) and (G2) may include the same conductive material.

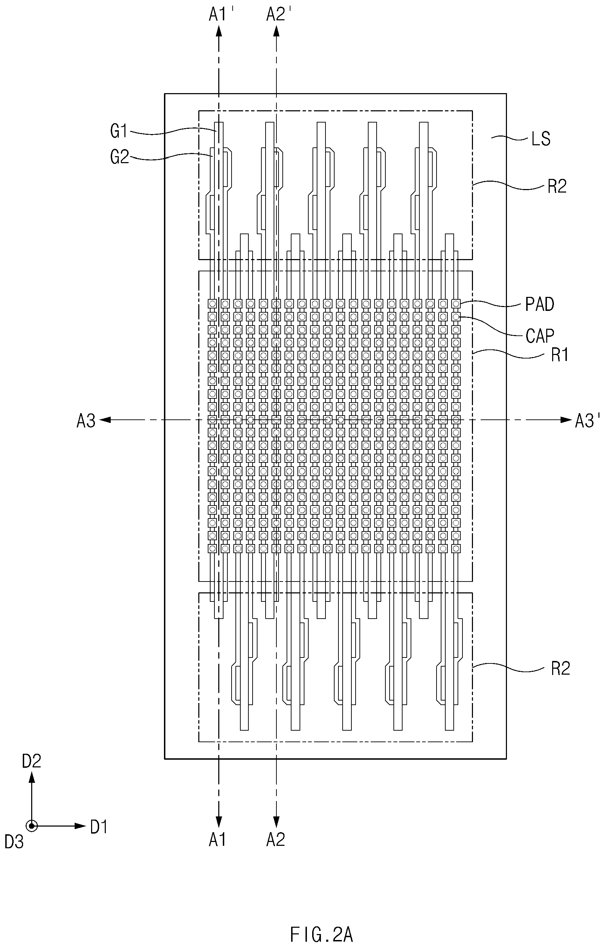

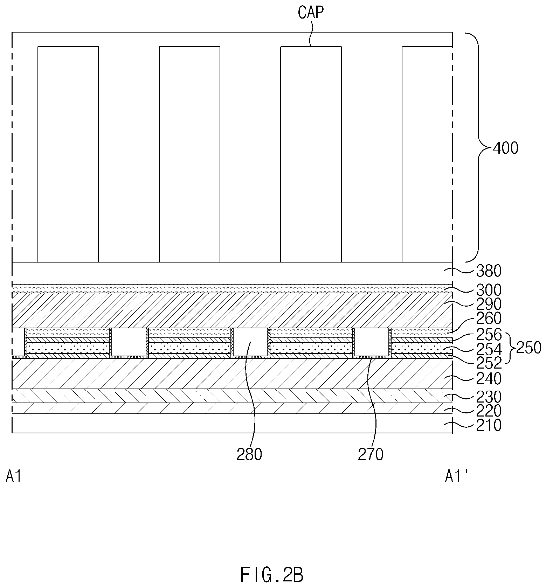

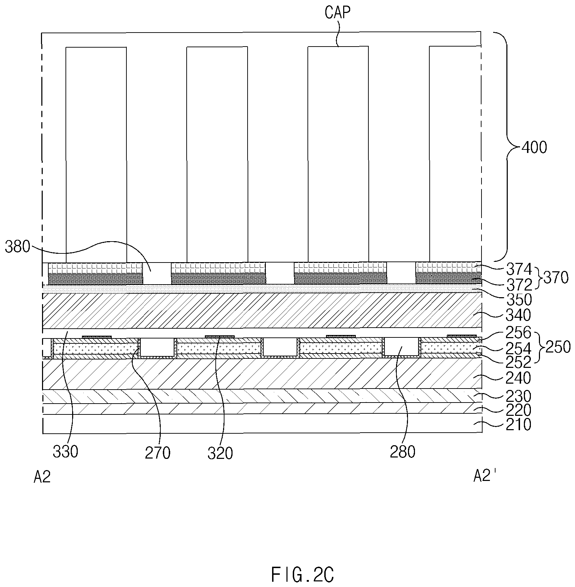

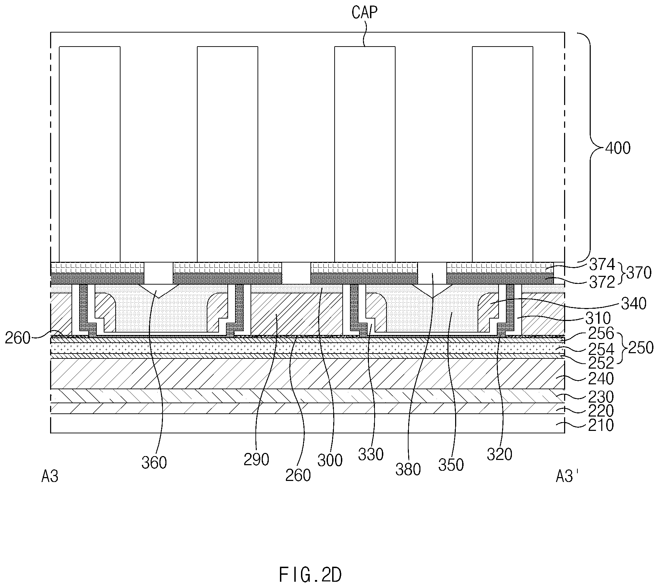

FIG. 2A is a schematic diagram illustrating a layout structure of the semiconductor device according to an embodiment of the present disclosure. FIG. 2B is a cross-sectional view illustrating the semiconductor device taken along the line A1-A1' shown in FIG. 2A, FIG. 2C is a cross-sectional view illustrating the semiconductor device taken along the line A2-A2' shown in FIG. 2A, and FIG. 2D is a cross-sectional view illustrating the semiconductor device taken along the line A3-A3' shown in FIG. 2A.

The layout structure of the semiconductor device viewed from the third direction (D3) is shown in FIG. 2A.

The semiconductor device may include a plurality of regions within the substrate (LS).

For example, the semiconductor device may include first and second regions (R1) and (R2). The first region (R1) may be a region in which a plurality of contact pads (PAD) and a plurality of capacitors (CAP) overlapping with the contact pads (PAD) are disposed. The second region (R2) may be a region that is adjacent to the first region (R1). The second region may include gates (G1, G2).

The plurality of capacitors (CAP) disposed in the first region (R1) may overlap with contact pads (PAD) disposed in a matrix structure. The capacitors (CAP) physical footprint may intersect or cover the contact pads (PAD). As shown in FIG. 1A, each capacitor (CAP) may be positioned on a corresponding contact pad (PAD). The footprint of each capacitor (CAP) may be the same as the footprint of a corresponding contact pad (PAD). However, the embodiments of the present disclosure are not limited in this way. For example, generally at least a portion of each capacitor (CAP) may overlap with a corresponding contact pad (PAD) or at least a portion of the corresponding contact pad (PAD).

The plurality of capacitors (CAP) may be arranged in a matrix structure. The plurality of capacitors (CAP) may be arranged in a matrix structure with respect to the contact pad (PAD) array. The plurality of capacitors (CAP) may be arranged in a matrix structure relative to or in alignment with the contact pad (PAD) array. Although the contact pads (PAD) and the capacitors (CAP) shown in FIG. 2A are arranged in a matrix structure including 20 rows and 20 columns for convenience of description, other embodiments are also possible. It should be noted that the plurality of capacitors (CAP) may be arranged in a shape with the highest degree of i nteg ration.

The second region (R2) may be a region in which contact portions included in the first gate (G1) or the second gate (G2) are disposed.

The contact portions may be respectively connected to conductive lines that provide control signals to the first gate (G1) or the second gate (G2). The semiconductor device may operate based on the control signals.

The bit line (BL) and the gates (G1, G2) included in the semiconductor device may extend in directions perpendicular to each other. The capacitors (CAP) may be located in the region where the bit line (BL) and the gates (G1, G2) overlap each other.

FIG. 2B is a cross-sectional view illustrating the center of the first gate G1 taken along a cutting line parallel to the second direction (D2). FIG. 2C is a cross-sectional view illustrating the center of the second gate (G2) taken along a cutting line parallel to the second direction (D2). FIG. 2D is a cross-sectional view illustrating the center of the bit line (BL) of FIG. 1A taken along a cutting line parallel to the first direction (D1).

Referring to FIGS. 2B, 2C, and 2D, a substrate layer 210, a silicide layer 220 formed over the substrate layer 210, and a first nitride layer 230 formed over the silicide layer 220 are illustrated.

The substrate layer 210 may include a silicon semiconductor material. For example, the substrate layer 210 may include silicon, monocrystalline silicon, polysilicon, amorphous silicon, silicon germanium, monocrystalline silicon germanium, polycrystalline silicon germanium, carbon-doped silicon, and the like.

The substrate layer 210 may include a plurality of control circuits configured to control the operation of the semiconductor device, and a region where the control circuits are provided may be referred to as a peripheral circuit region.

The silicide layer 220 formed over the substrate layer 210 may include a metal silicide material such as cobalt silicide (CoSi). The silicide layer 220 is provided in the semiconductor device, so that the operation resistance of the semiconductor device may decrease. In addition, the silicide layer 220 may serve as a protective layer for the substrate layer 210, and may thus prevent damage to the substrate layer 210 during a semiconductor fabrication process.

The first nitride layer 230 formed over the silicide layer 220 may refer to a layer containing silicon nitride. Since the first nitride layer 230 includes silicon nitride, damage to the substrate layer 210 may be prevented during a high-temperature semiconductor fabrication process.

Referring to FIGS. 2B, 2C and 2D, the first oxide layer 240 may be disposed over the first nitride layer 230. The first oxide layer 240 may be a layer containing, for example, silicon oxide, and the like. The first oxide layer 240 may operate as an insulation layer together with the first nitride layer 230.

As the first nitride layer 230 and the first oxide layer 240 are provided in the semiconductor device, the control circuits included in the substrate layer 210 may be electrically isolated from the bit line 250.

The bit line 250 disposed over the first oxide layer 240 may include a plurality of layers extending in the first direction (D1). For example, the bit line 250 may include a first bit-line layer 252 containing titanium nitride (TiN), a second bit-line layer 254 containing tungsten (W), and a third bit-line layer 256 containing titanium nitride (TiN).

Since the bit line 250 includes a plurality of layers, the operation resistance of the semiconductor device may be adjusted.

The first bit line layer 252 and the third bit line layer 256 included in the bit line 250 may prevent the second bit-line layer 254 from being oxidized by exposure to oxygen. When the second bit line layer 254 is exposed to oxygen, tungsten (W) may be oxidized, thereby causing disconnection and defects.

In addition, titanium nitride (TiN) included in the first bit line layer 252 may have a higher adhesion to silicon oxide than tungsten (W), and the first bit-line layer 252 is disposed between the first oxide layer 240 and the second bit line layer 254, resulting in improvement in the mechanical stability of the bit lines 250.

After depositing the plurality of layers, the bit lines 250 may be formed through an etching process that uses a mask.

The adjacent bit lines 250 may be electrically isolated from each other by a second bit-line isolation layer 270 and a third bit-line isolation layer 280. In some embodiments, the second bit-line isolation layer 270 may include silicon nitride, and the third bit-line isolation layer 280 may include silicon oxide. The bit lines 250 and the first gate 290 may be isolated from each other by a first bit-line isolation layer 260.

The second bit-line isolation layer 270 and the third bit-line isolation layer 280 may function as spacers that electrically isolate the adjacent bit lines 250 from each other.

The first bit-line isolation layer 260 may be disposed over each bit line 250 to electrically isolate the bit line 250 from the first gate 290. The first bit-line isolation layer 260 may include silicon oxide (SiCO) containing carbon.

Referring to FIGS. 2C and 2D, an active region 320 electrically connected to at least a portion of the bit lines 250 may be disposed over the bit lines 250. The active region 320 may be electrically isolated from the second gate 340 by the second gate oxide layer 330.

The first gate 290 and the second gate 340 may include a metal, a metal mixture, a metal alloy, titanium nitride, tungsten, polysilicon, or a combination thereof. For example, the first gate 290 and the second gate 340 may include titanium nitride.

Referring to FIG. 2D, the first gate oxide layer 310 may be disposed not only over the first bit-line isolation layer 260, but also at sidewalls of the first gate 290. Although not shown in FIGS. 2B to 2D, at least a portion of the first gate oxide layer 310 may be disposed over the third bit-line isolation layer 280.

The first gate oxide layer 310 may electrically isolate the first gate 290 from the bit line 250 or the active region 320. The first gate oxide layer 310 may include an insulation material such as silicon oxide.

A second nitride layer 300 may be provided over the first gate 290 to electrically isolate the first gate 290 and the contact pad 370 from each other.

Adjacent second gates 340 may be electrically isolated from each other by a third nitride layer 350. In addition, the second gates 340 and the contact pad 370 may be isolated from each other by the third nitride layer 350.

A second oxide layer 360 may be disposed over the third nitride layer 350 located between the second gates 340. Contact portions to which the second gate 340 and the conductive lines are connected may be formed in the second gate 340 using a difference in etch rate between the second oxide layer 360 and the third nitride layer 350.

The contact portions corresponding to the first gate G1 or the contact portions corresponding to the second gate G2 may be arranged sparsely in a zigzag pattern in the first direction (D1), as shown in FIG. 2A. The gates (G1, G2) may be electrically connected to a conductive line that transmits control signals through the contact portions.

The active region 320 may include a horizontal portion formed to contact the bit line 250, and a vertical portion formed to extend in the vertical direction (D3) while being disposed between the first gate 290 and the second gate 340. The active region 320 may include, for example, an oxide semiconductor material, and the oxide semiconductor material may include indium gallium zinc oxide (IGZO).

In another embodiment, the active region 320 may include doped polysilicon, undoped polysilicon, amorphous silicon, indium zinc oxide (IZO), indium tin oxide (ITO), indium oxide (InOs), and the like.

Since IGZO has low leakage current characteristics and the active region 320 is formed of IGZO, a semiconductor device with low standby power may be implemented.

In addition, since the active region 320 includes IGZO, fabrication process difficulty may be reduced, and the active region 320 with a three-dimensional (3D) structure including vertical and horizontal portions may be easily formed.

One end of the vertical portion included in the active region 320 may contact the contact pad 370 that connects the capacitor (CAP) and the active region 320 to each other.

The contact pad 370 may include a plurality of layers to reduce contact resistance between the active region 320 and the capacitor (CAP).

Referring to FIGS. 2C and 2D, the width of the contact pad 370 may be larger than the width of the vertical portion. Since the contact pad 370 has a larger width than the vertical portion, a contact area between the capacitor (CAP) and the contact pad 370 may be secured, thereby guaranteeing the mechanical stability of the semiconductor device.

The contact pad 370 may include a first pad layer 372 and a second pad layer 374.

The first pad layer 372 includes the same material as the active region 320 for reducing interfacial resistance between the contact pad 370 and the active region 320. For example, the first pad layer 372 may include an oxide semiconductor material such as IGZO.

In another embodiment, the first pad layer 372 may include indium zinc oxide (IZO), indium tin oxide (ITO), indium oxide (InOs), and the like.

The second pad layer 374 formed over the first pad layer 372 may include titanium nitride (TiN). Since the second pad layer 374 is formed, interfacial resistance between the contact pad 370 and the capacitor (CAP) may be reduced.

The capacitor (CAP) disposed over the contact pad 370 may be arranged so that at least a portion thereof overlaps with the contact pad 370.

The fourth nitride layer 380 may electrically isolate the adjacent contact pads 370 from each other. The fourth nitride layer 380 may be provided to surround the contact pad 370. In other words, the fourth nitride layer 380 may be disposed between the adjacent contact pads 370.

The capacitors (CAP) may be disposed within a storage element layer 400. The capacitors (CAP) may be electrically isolated from each other by the insulation layer, and each capacitor (CAP) may operate as a data storage unit for writing or reading data according to a control signal applied to the semiconductor device.

Each capacitor (CAP) may include a capacitor dielectric layer and a plurality of storage electrodes. Depending on the control signal provided to the first gate 290 and the second gate 340, whether or not a voltage is provided to the capacitor (CAP) may be determined, and the magnitude of a voltage provided to the capacitor (CAP) may also be determined. The semiconductor device may read out stored data based on a signal corresponding to the voltage of the capacitor (CAP).

The capacitor (CAP) may have a shape extending in the vertical direction (i.e., the third direction D3) with respect to the substrate layer 210 within the storage element layer 400. More specifically, the capacitor (CAP) may be formed in a cylindrical or pillar shape. As the capacitor (CAP) has a cylindrical or pillar shape, the capacitor (CAP) density can increase within the same area. As the density of the capacitor (CAP) increases, the data storage capacity of the semiconductor device may increase. Each capacitor (CAP) may correspond to one contact pad 370, and one contact pad 370 may contact one capacitor (CAP).

Referring to the semiconductor device according to the embodiments of FIGS. 2A to 2D, a ground voltage may be provided to the first gate 290 at data read/write time points, and a word line driving voltage may be provided to the second gate 340 at data read/write time points. When a ground voltage is provided to the first gate 290, the first gate 290 may provide a back-bias voltage to the semiconductor device.

The first gate 290 may be disposed between two adjacent second gates 340. As a ground voltage is provided to the first gate 290, adjacent second gates 340 may be electrically isolated from each other.

Such electrical isolation between the adjacent second gates 340 may mean that electrical interference between the adjacent second gates 340 is blocked.

As the semiconductor device is reduced in size, the distance between the second gates 340 may become shorter. When the distance between the second gates 340 is shortened, a coupling phenomenon may occur between the adjacent second gates 340 due to a word line driving voltage provided to each of the second gates 340. Due to the coupling phenomenon, unexpected errors may occur during data read/write operations of the semiconductor device.

In some embodiments, the first gate 290 is disposed between the second gates 340 and the ground voltage is provided to the first gate 290, so that the coupling phenomenon between the second gates 340 is prevented, thereby improving the operation characteristics of the semiconductor device. In addition, since a ground voltage is provided to the first gate 290, the coupling phenomenon between adjacent active regions 320 may be prevented during operation of the semiconductor device.

In addition, the first gate 290 provided with a ground voltage may provide a back-bias voltage to the semiconductor device, thereby efficiently suppressing leakage current (e.g., gate induced drain leakage (GIDL)) and improving electrical characteristics of the semiconductor device. In addition, the first gate 290 may control threshold voltage characteristics of the semiconductor device by providing a back-bias voltage to the semiconductor device.

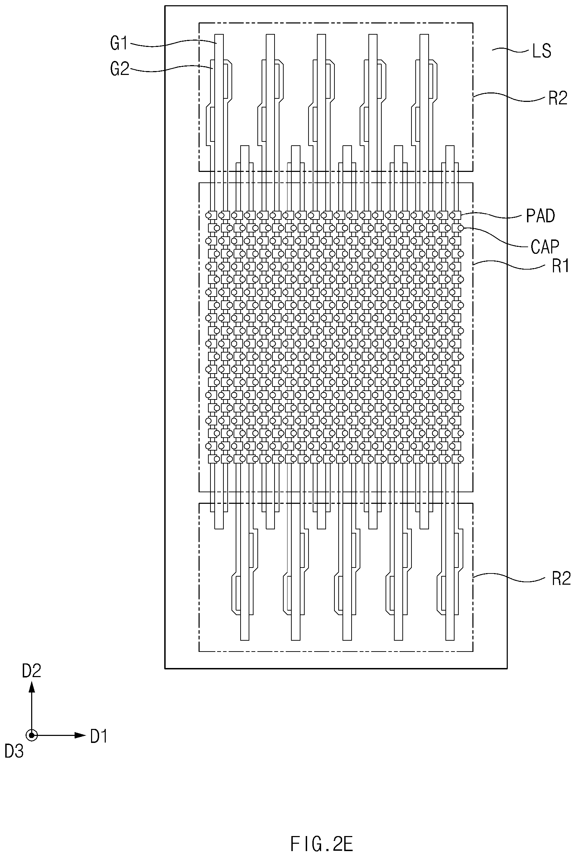

FIG. 2E is a schematic diagram illustrating a layout structure of the semiconductor device according to another embodiment of the present disclosure.

Unlike FIG. 2A, the plurality of capacitors (CAP) included in the semiconductor device shown in FIG. 2E may be arranged in a zigzag shape with respect to the plurality of contact pad (PAD) arrays arranged in a matrix structure within the first region (R1).

More specifically, at least a portion of each capacitor (CAP) may overlap with the contact pad (PAD). The capacitors (CAP) may be repeatedly arranged in a zigzag pattern with respect to the plurality of contact pads (PAD) overlapping one second gate (G2). As the capacitors (CAP) are arranged in a zigzag shape, a separation distance between the adjacent capacitors (CAP) may be secured.

Since the separation distance between the capacitors (CAP) is secured, noise that may occur by the adjacent capacitors (CAP) may be reduced.

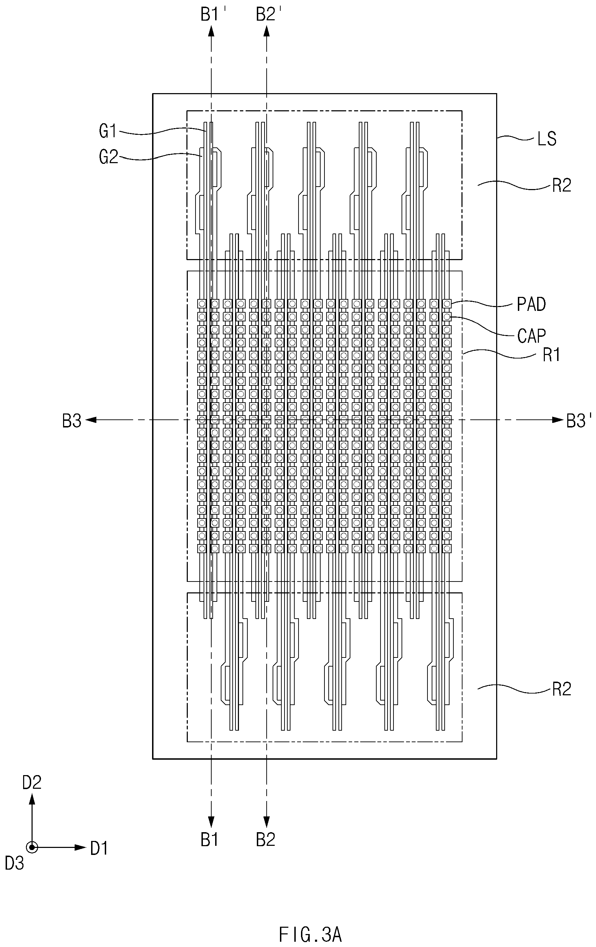

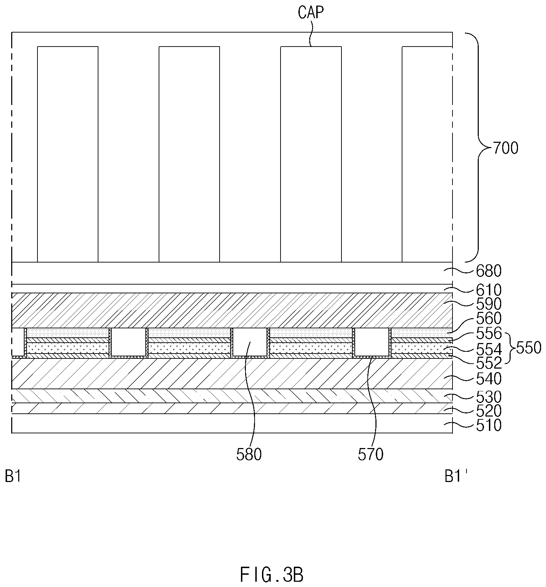

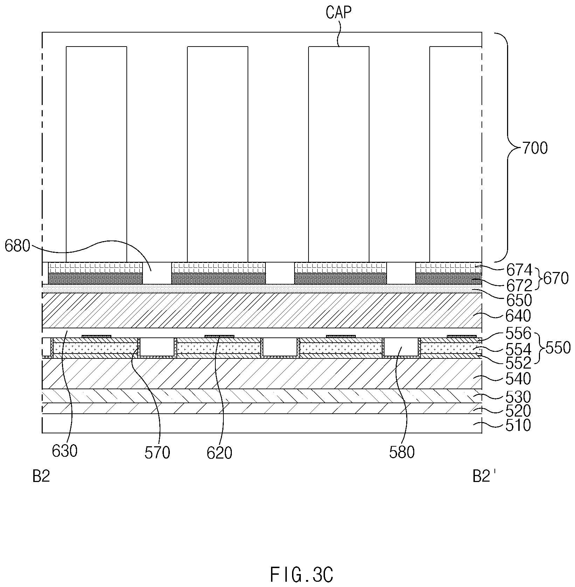

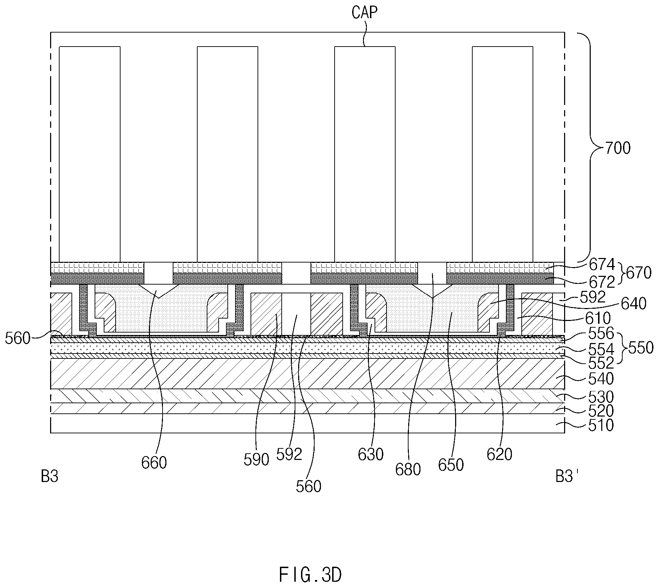

FIG. 3A is a schematic diagram illustrating a semiconductor device according to another embodiment of the present disclosure. FIG. 3B is a cross-sectional view illustrating the semiconductor device taken along the line B1-B1' shown in FIG. 3A, FIG. 3C is a cross-sectional view illustrating the semiconductor device taken along the line B2-B2' shown in FIG. 3A, and FIG. 3D is a cross-sectional view illustrating the semiconductor device taken along the line B3-B3' shown in FIG. 3A.

The layout structure of the semiconductor device viewed from the third direction (D3) is shown in FIG. 3A.

The semiconductor device may include a plurality of regions within the substrate (LS).

For example, the semiconductor device may include a first region (R1) in which a plurality of contact pads (PAD) and a plurality of capacitors (CAP) overlapping with the contact pads (PAD) are disposed, and a second region (R2) that is adjacent to the first region (R1). In the second region(R2), the gates (G1, G2) are connected to signal lines.

The plurality of capacitors (CAP) disposed in the first region (R1) may overlap with contact pads (PAD) disposed in a matrix structure.

The plurality of capacitors (CAP) may be arranged in a form with the highest degree of integration.

The pad regions of FIG. 3A may be arranged in a matrix structure with 20 rows and 20 columns, but this is only an example.

The second region (R2) may be a region in which contact portions included in the first gate (G1) or the second gate (G2) are disposed.

Each contact portion may be connected to conductive lines that provide control signals to the first gate (G1) or the second gate (G2). The semiconductor device may operate based on the control signal.

The bit line (BL) and the gates (G1, G2) included in the semiconductor device may extend in directions perpendicular to each other, and the capacitors (CAP) may be located in the region where the bit line (BL) and the gates (G1, G2) overlap each other.

Unlike the embodiment of FIG. 2A, in the embodiment of FIG. 3A, two first gates (G1) may be disposed between two adjacent second gates (G2). Contact portions of the first gates (G1) may be commonly connected to a conductive line connected to contact portions of the second gates (G2) adjacent to the first gates G1.

FIG. 3B is a cross-sectional view illustrating the center of the first gate G1 taken along a cutting line parallel to the second direction (D2). FIG. 3C is a cross-sectional view illustrating the center of the second gate (G2) taken along a cutting line parallel to the second direction (D2). FIG. 3D is a cross-sectional view illustrating the center of the bit line (BL) of FIG. 1B taken along a cutting line parallel to the first direction (D1).

Referring to FIGS. 3B, 3C, and 3D, a substrate layer 510, a silicide layer 520 formed over the substrate layer 510, and a first nitride layer 530 formed over the silicide layer 520 are illustrated.

The substrate layer 510 may include a silicon semiconductor material. For example, the substrate layer 510 may include silicon, monocrystalline silicon, polysilicon, amorphous silicon, silicon germanium, monocrystalline silicon germanium, polycrystalline silicon germanium, carbon-doped silicon, and the like.

The substrate layer 510 may include a plurality of control circuits configured to control the operation of the semiconductor device, and a region where the control circuits are provided may be referred to as a peripheral circuit region.

The silicide layer 520 formed over the substrate layer 510 may include a metal silicide material such as cobalt silicide (CoSi). The silicide layer 520 is provided in the semiconductor device, so that the operation resistance of the semiconductor device may decrease. In addition, the silicide layer 520 may serve as a protective layer for the substrate layer 510, and may thus prevent damage to the substrate layer 510 during a semiconductor fabrication process.

The first nitride layer 530 formed over the silicide layer 520 may refer to a layer containing silicon nitride. Since the first nitride layer 530 includes silicon nitride, damage to the substrate layer 510 may be prevented during a high-temperature semiconductor fabrication process.

Referring to FIGS. 3B, 3C and 3D, the first oxide layer 540 may be disposed over the first nitride layer 530. The first oxide layer 540 may be a layer containing, for example, silicon oxide, and the like. The first oxide layer 540 may operate as an insulation layer together with the first nitride layer 530.

As the first nitride layer 530 and the first oxide layer 540 are provided in the semiconductor device, the control circuits included in the substrate layer 510 may be electrically isolated from the bit line 550.

Bit line 550 may be disposed over the first oxide layer 540 and may include a plurality of layers extending in the first direction (D1). For example, the bit line 550 may include a first bit-line layer 552 containing titanium nitride (TiN), a second bit-line layer 554 containing tungsten (W), and a third bit-line layer 556 containing titanium nitride (TiN).

Since the bit line 550 includes a plurality of layers, the operation resistance of the semiconductor device may be adjusted.

The first bit line layer 552 and the third bit line layer 556 included in the bit line 550 may prevent the second bit-line layer 554 from being oxidized by exposure to oxygen. When the second bit line layer 554 is exposed to oxygen, tungsten (W) may be oxidized, thereby causing disconnection and defects.

In addition, titanium nitride (TiN) included in the first bit line layer 552 may have a higher adhesion to silicon oxide than tungsten (W), and the first bit-line layer 552 is disposed between the first oxide layer 540 and the second bit line layer 554, resulting in improvement in the mechanical stability of the bit lines 550. After depositing the plurality of layers, the bit lines 550 may be formed through an etching process that uses a mask.

Adjacent bit lines 550 may be electrically isolated from each other by a second bit-line isolation layer 570 and a third bit-line isolation layer 580. In some embodiments, the second bit-line isolation layer 570 may include silicon nitride, and the third bit-line isolation layer 580 may include silicon oxide.

An isolation oxide layer 592 may be disposed between two adjacent first gates 590. The two first gates 590 and the isolation oxide layer 592 may be disposed over the first bit-line isolation layer 560.

Additionally, a first gate oxide layer 610 may be arranged to surround the two adjacent first gates 590 and the isolation oxide layer 592. The first gate oxide layer 610 may electrically isolate the active region 620 and the first gate 590 from each other, and may include an insulation material such as silicon oxide.

The first gates 590 and the bit lines 550 may be electrically isolated from each other by a first bit-line isolation layer 560.

The second bit-line isolation layer 570 and the third bit-line isolation layer 580 may function as spacers that electrically isolate the adjacent bit lines 550 from each other.

The first bit-line isolation layer 560 may be disposed over each bit line 550 to electrically isolate the bit lines 550 from the first gates 590. The first bit-line isolation layer 560 may include silicon oxide (SiCO) containing carbon.

Referring to FIGS. 3C and 3D, an active region 620 electrically connected to at least a portion of the bit lines 550 may be disposed over the bit lines 550. The active region 620 may be electrically isolated from the second gates 640 by the second gate oxide layer 630.

The first and second gates 590 and 640 may include a metal, a metal mixture, a metal alloy, titanium nitride, tungsten, polysilicon, or a combination thereof. For example, the first and second gates 590 and 640 may include titanium nitride.

Referring to FIG. 3D, the isolation oxide layer 592 may be disposed between two adjacent first gates 590. The isolation oxide layer 592 may be formed before depositing the first gate 590 over the bit lines 550. The isolation oxide layer 592 may extend in a direction parallel to the direction (e.g., D2 direction) in which the first gate 590 extends.

The isolation oxide layer 592 may be formed by etching an oxide layer disposed over the bit lines 550 and the bit-line isolation layer 580, after forming the bit lines 550, the first bit-line isolation layer 560, the second bit-line isolation layer 570, and the third bit-line isolation layer 580.

A titanium nitride layer may be formed over the isolation oxide layer 592, and the titanium nitride layer may be etched so that the isolation oxide layer 592 is disposed between the first gates 590. Adjacent first gates 590 may be electrically isolated from each other by the isolation oxide layer 592.

Adjacent second gates 640 may be electrically isolated from each other by a third nitride layer 650.

A second oxide layer 660 may be disposed over the third nitride layer 650 located between the second gates 640.

Contact portions to which the first gates 590 and the conductive lines are connected may be formed in the first gates 590 using a difference in etch rate between the second oxide layer 660 and the third nitride layer 650. Contact portions through which the second gates 640 and the conductive lines are connected may be formed in the second gates 640.

In some embodiments, the contact portions of the adjacent first gates 590 and the contact portions of the second gates 640 may be connected to one conductive line.

The contact portions corresponding to the first gates 590 or the contact portions corresponding to the second gates 640 may be arranged sparsely in a zigzag pattern in the first direction (D1), as shown in FIG. 3A.

The active region 620 may include a horizontal portion formed to contact the bit lines 550, and a vertical portion formed to extend in the vertical direction (D3) while being disposed between the first and second gates 590 and 640. The active region 620 may include, for example, an oxide semiconductor material, and the oxide semiconductor material may include indium gallium zinc oxide (IGZO).

In another embodiment, the active region 620 may include doped polysilicon, undoped polysilicon, amorphous silicon, indium zinc oxide (IZO), indium tin oxide (ITO), indium oxide (InOs), and the like.

Since IGZO has low leakage current characteristics and the active region 620 is formed of IGZO, a semiconductor device with low standby power may be implemented.

In addition, since the active region 620 includes IGZO, fabrication process difficulty may be reduced, and the active region 620 with a three-dimensional (3D) structure including vertical and horizontal portions may be easily formed.

One end of the vertical portion included in the active region 620 may contact the contact pad 670 that connects the capacitor (CAP) and the active region 620 to each other.

The contact pad 670 may include a plurality of layers to reduce contact resistance between the active region 620 and the capacitor (CAP).

Referring to FIGS. 3C and 3D, the width of the contact pad 670 may be larger than the width of the vertical portion. Since the contact pad 670 has a larger width than the vertical portion, a contact area between the capacitor (CAP) and the contact pad 670 may be secured, thereby guaranteeing the mechanical stability of the semiconductor device.

The contact pad 670 may include a first pad layer 672 and a second pad layer 674.

Since the first pad layer 672 includes the same material as the active region 620, interfacial resistance between the contact pad 670 and the active region 620 may be reduced. For example, the first pad layer 672 may include an oxide semiconductor material such as IGZO.

In another embodiment, the first pad layer 672 may include indium zinc oxide (IZO), indium tin oxide (ITO), indium oxide (InOs), and the like.

The second pad layer 674 formed over the first pad layer 672 may include titanium nitride (TiN). Since the second pad layer 674 is formed, interfacial resistance between the contact pad 670 and the capacitor (CAP) may be reduced.

The capacitor (CAP) disposed over the contact pad 670 may be arranged so that at least a portion thereof overlaps with the contact pad 670.

The fourth nitride layer 680 may electrically isolate the adjacent contact pads 670 from each other. The fourth nitride layer 680 may be provided to surround the contact pad 670. The fourth nitride layer 680 may be disposed between the adjacent contact pads 670.

The capacitor (CAP) may be disposed within a storage element layer 700. The capacitors (CAP) may be electrically isolated from each other by the insulation layer, and each capacitor (CAP) may operate as a data storage unit for writing or reading data according to a control signal applied to the semiconductor device.

Each capacitor (CAP) may include a capacitor dielectric layer and a plurality of storage electrodes. Depending on the control signal provided to the first and second gates 590 and 640, whether or not a voltage is provided to the capacitor (CAP) may be determined, and the magnitude of a voltage provided to the capacitor (CAP) may also be determined. The semiconductor device may read out stored data based on a signal corresponding to the voltage of the capacitor (CAP).

The capacitor (CAP) may have a shape extending in the vertical direction (i.e., the third direction D3) with respect to the substrate layer 510 within the storage element layer 700. More specifically, the capacitor (CAP) may be formed in a cylindrical or pillar shape. As the capacitor (CAP) has a cylindrical or pillar shape, the density of the capacitor (CAP) can increase within the same area. As the density of the capacitor (CAP) increases, the data storage capacity of the semiconductor device may increase. Each capacitor (CAP) may correspond to one contact pad 670, and one contact pad 670 may contact one capacitor (CAP).

Referring to the semiconductor device according to the embodiments of FIGS. 3A to 3D, a word line driving voltage may be provided to the first and second gates 590 and 640 adjacent to the first gates 590 at data read/write time points.

As the word line driving voltage is applied to the first and second gates 590 and 640 adjacent to the first gates 590, two channel regions may be formed at both side surfaces of the active region 620.

Since two channel regions are formed, electron mobility may increase, and the semiconductor device may be easily controlled with a low driving voltage.

The semiconductor device according to another embodiment may include the first and second gates 590 and 640, thereby implementing an evolved semiconductor device with improved operating current characteristics and higher electron mobility.

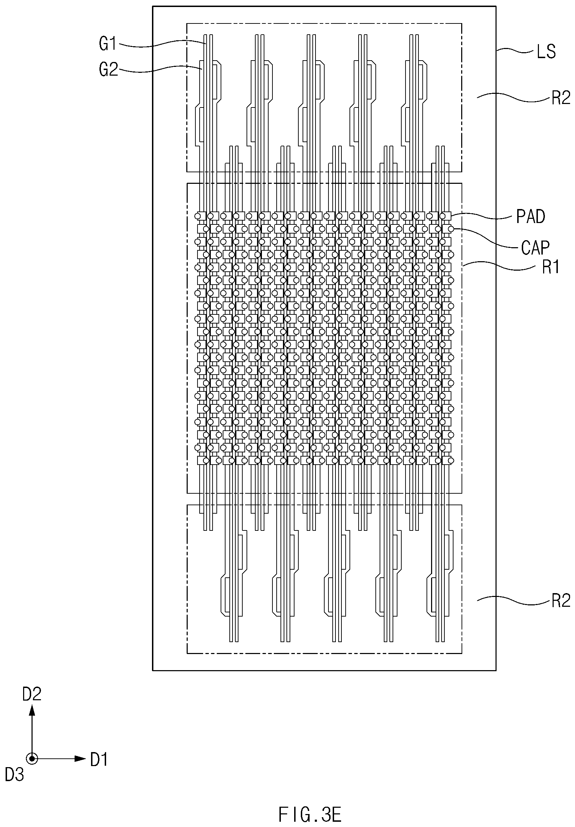

FIG. 3E is a schematic diagram illustrating a layout structure of the semiconductor device according to another embodiment of the present disclosure.

Unlike FIG. 3A, the plurality of capacitors (CAP) included in the semiconductor device shown in FIG. 3E may be arranged in a zigzag shape with respect to the plurality of contact pad (PAD) arrays arranged in a matrix structure within the first region (R1).

More specifically, at least a portion of each capacitor (CAP) may overlap with contact pad (PAD). The capacitors (CAP) may be repeatedly arranged in a zigzag pattern with respect to the plurality of contact pads (PAD) overlapping one second gate (G2). As the capacitors (CAP) are arranged in a zigzag shape, a separation distance between the adjacent capacitors (CAP) may be secured.

Since the separation distance between the capacitors (CAP) is secured, noise that may occur by the adjacent capacitors (CAP) may be reduced.

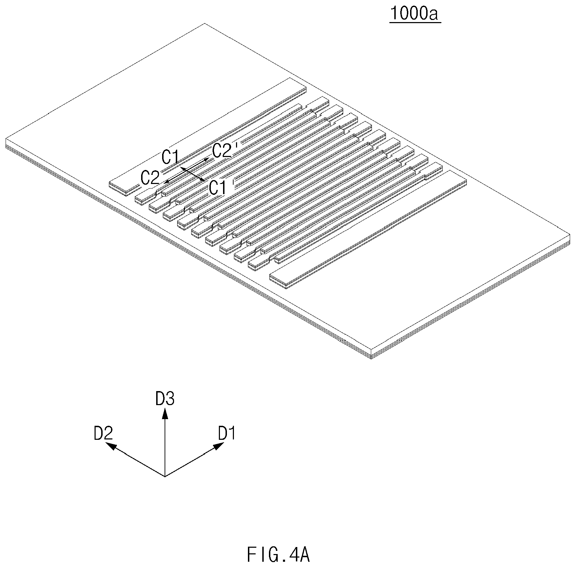

FIGS. 4A to 19C are views illustrating a method for manufacturing a semiconductor device according to an embodiment of the present disclosure.

FIG. 4A is a perspective view 1000a illustrating a method for manufacturing a semiconductor device in which the bit lines 250 are formed over the first oxide layer 240.

Referring to the perspective view 1000a, the bit lines 250 may extend in the first direction (D1) on the first oxide layer 240 formed over the substrate layer 210, and may be consecutively arranged in the second direction (D2).

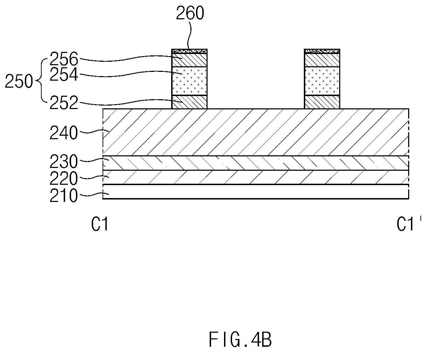

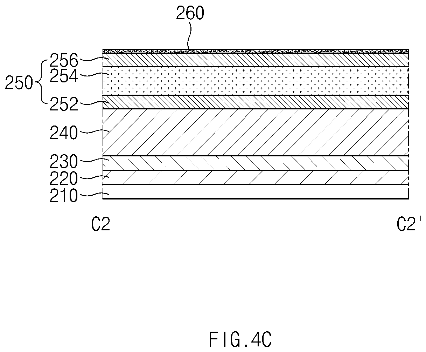

FIG. 4B is a cross-sectional view illustrating the semiconductor device taken along the line C1-C1' shown in FIG. 4A, and FIG. 4C is a cross-sectional view illustrating the semiconductor device taken along the line C2-C2' shown in FIG. 4A

Referring to FIG. 4B showing a cross-sectional view illustrating the adjacent bit lines 250 and FIG. 4C showing a cross-sectional view illustrating the semiconductor device taken along the center of the bit line 250, the bit lines, each of which includes a first bit-line layer 252, a second bit-line layer 254, and a third bit-line layer 256, may be arranged to be spaced apart from each other at preset intervals over the first oxide layer 240. The bit-line isolation layer 260 may be disposed over the bit line 250.

The layout structure of the bit line 250 may vary depending on the shape of a mask used in the etching process.

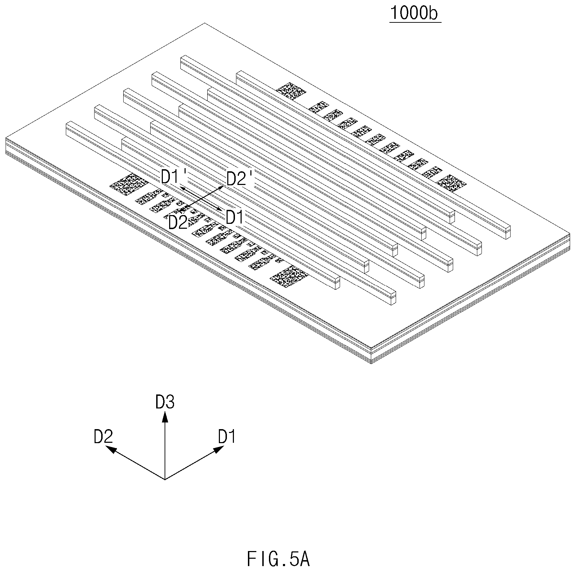

FIG. 5A is a perspective view 1000b illustrating a method for manufacturing a semiconductor device in which the first gate 290 is formed over a first bit-line isolation layer 260, a second bit-line isolation layer 270, and a third bit-line isolation layer 280.

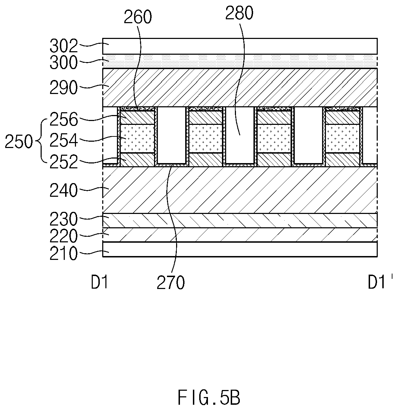

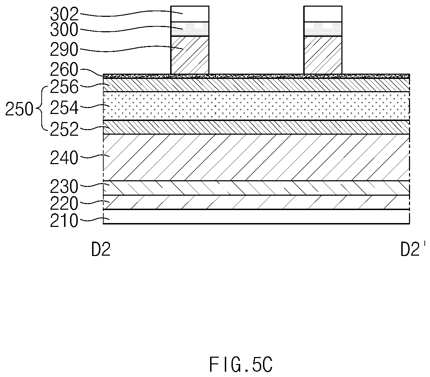

FIG. 5B is a cross-sectional view illustrating the semiconductor device taken along the line D1-D1' shown in FIG. 5A, and FIG. 5C is a cross-sectional view illustrating the semiconductor device taken along the line D2-D2' shown in FIG. 5A.

Referring to FIG. 5B showing a cross-sectional view illustrating the semiconductor device taken along the center of the first gate 290 and FIG. 5C showing a cross-sectional view illustrating the semiconductor device taken along the first gates 290 adjacent to each other, the second bit-line isolation layer 270 and the third bit-line isolation layer 280 may be formed between the bit lines 250 to electrically isolate the adjacent bit lines 250 from each other.

After the second bit-line isolation layer 270 containing silicon nitride is formed over the bit line 250 and the first bit-line isolation layer 260, and the third bit-line isolation layer 280 containing silicon oxide is formed over the second bit-line isolation layer 270, a chemical planarization process such as a chemical mechanical polishing (CMP) process may be performed, so that a second bit-line isolation layer 270 and a third bit-line isolation layer 280 may be formed between the bit lines.

The second bit-line isolation layer 270 and the third bit-line isolation layer 280 may function as spacers that electrically isolate adjacent bit lines 250 from each other.

A method for forming the first gate 290 is as follows. A titanium nitride (TiN) layer, a silicon nitride layer, and a silicon oxide layer are sequentially formed over the first bit-line isolation layer 260, the second bit-line isolation layer 270, and the third bit-line isolation layer 280, and are then etched using a mask including a Spin on Carbon (SoC) layer and a silicon oxynitride (SiON) layer, resulting in formation of the first gate 290.

The layout structure of the first gate 290 may vary depending on the shape of a mask used in the etching process.

Since a silicon nitride layer and a silicon oxide layer are formed over the titanium nitride (TiN) layer, damage to the titanium nitride (TiN) layer may be prevented during the etching process.

After etching the silicon nitride layer and the silicon oxide layer, the silicon nitride layer may be used as a second nitride layer 300 and the silicon oxide layer may be used as a protective oxide layer 302.

The second nitride layer 300 and the protective oxide layer 302 may prevent damage to the first gate 290 during the semiconductor fabrication process, and may electrically isolate the first gate 290 from other components (e.g., active regions) contained in the semiconductor device.

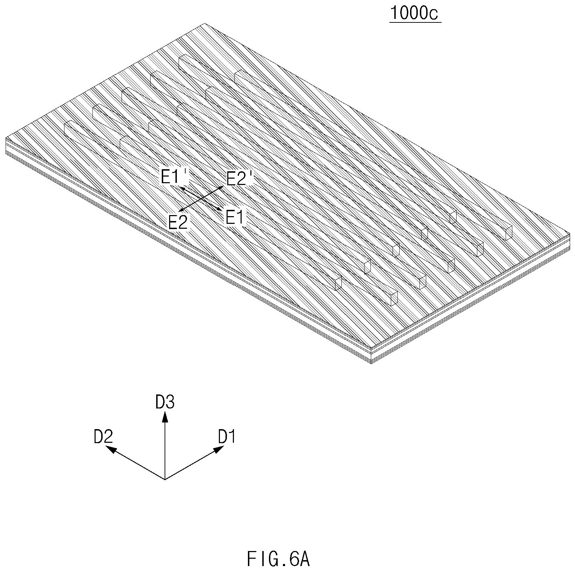

FIG. 6A is a perspective view 1000c illustrating a method for manufacturing a semiconductor device in which a first gate oxide layer 310 and a protective silicon layer 312 are formed over the first gate 290.

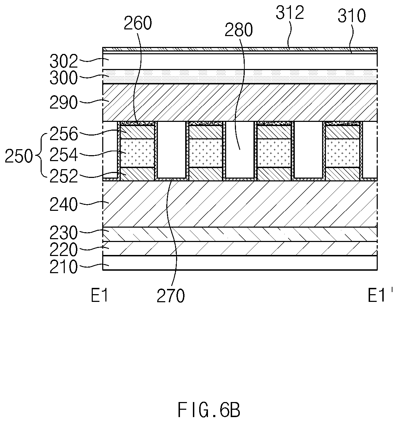

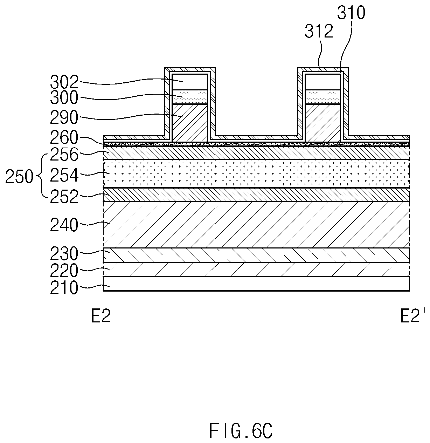

FIG. 6B is a cross-sectional view illustrating the semiconductor device taken along the line E1-E1' shown in FIG. 6A, and FIG. 6C is a cross-sectional view illustrating the semiconductor device taken along the line E2-E2' shown in FIG. 6A.

Referring to FIG. 6B showing a cross-sectional view illustrating the semiconductor device taken along the center of the first gate 290 and FIG. 6C showing a cross-sectional view illustrating the semiconductor device taken along the first gates 290 adjacent to each other, a second nitride layer 300 and a protective oxide layer 302 may be formed over the first gate, and a first gate oxide layer 310 and a protective silicon layer 312 may be formed to overlap with protective oxide layer 302, the first bit-line isolation layer 260, and the third bit-line isolation layer 280.

Since the protective silicon layer 312 is provided in the semiconductor device, the first gate oxide layer 310 disposed below the protective silicon layer 312 may be protected during the etching process.

The protective silicon layer 312 may be a layer containing polysilicon. Since the protective silicon layer 312 is provided in the semiconductor device, the first bit-line isolation layer 260 disposed over the bit line 250 may be etched to form the active region 320 contacting at least a portion of the bit line 250. In this case, damage to the first gate oxide layer 310 may be prevented.

When the protective silicon layer 312 is not provided, the first gate oxide layer 310 may be directly exposed to plasma during the etching process, and side effects such as a thickness reduction of the first gate oxide layer 310 and surface defects caused by plasma may occur.

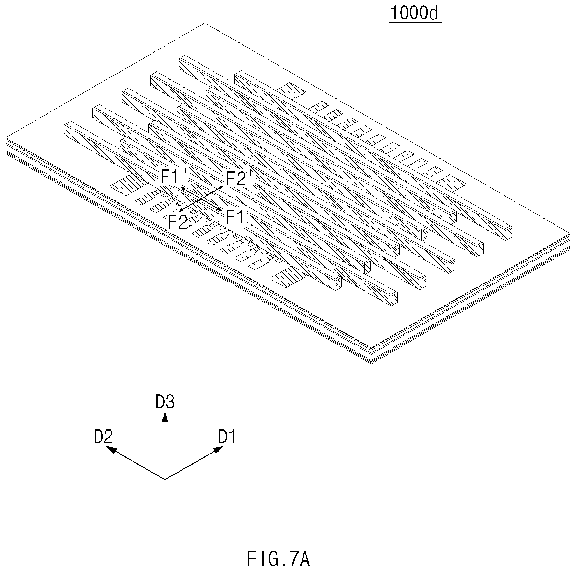

FIG. 7A is a perspective view 1000d illustrating a method for manufacturing a semiconductor device in which at least a portion of the protective silicon layer 312, at least a portion of the first gate oxide layer 310, and at least a portion of the first bit-line isolation layer 260 are etched.

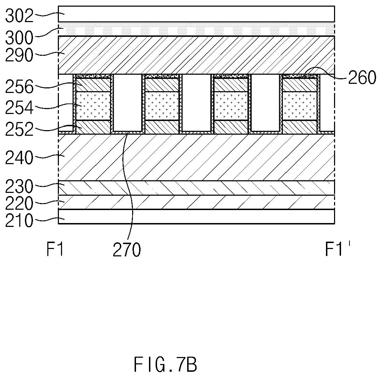

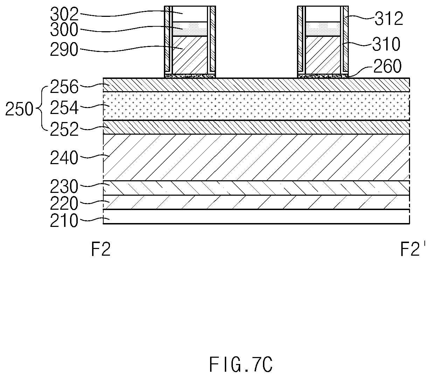

FIG. 7B is a cross-sectional view illustrating the semiconductor device taken along the line F1-F1' shown in FIG. 7A, and FIG. 7C is a cross-sectional view illustrating the semiconductor device taken along the line F2-F2' shown in FIG. 7A.

Referring to FIG. 7B showing a cross-sectional view illustrating the semiconductor device taken along the center of the first gate 290 and FIG. 7C showing a cross-sectional view illustrating the semiconductor device taken along the first gates 290 adjacent to each other, after completion of the plasma etching process, the first gate oxide layer 310 may be disposed along the sidewall of the first gate 290 and the first bit-line isolation layer 260 disposed below the first gate 290, and the protective silicon layer 312 may remain on the first gate oxide layer 310 along the sidewall of the first gate 290.

The first gate oxide layer 310 disposed between the protective silicon layer 312 and the first gate 290 may be protected from plasma by the remaining protective silicon layer 312. Thereafter, the remaining protective silicon layer 312 may be selectively removed through a separate silicon etching process.

The silicon etching process may include, for example, a wet etching process.

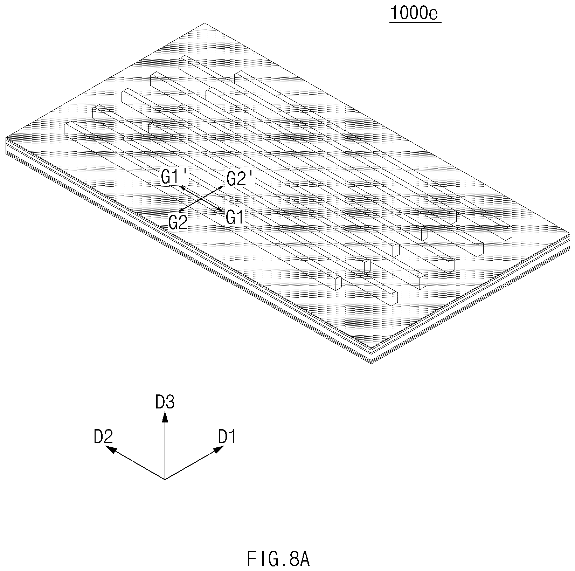

FIG. 8A is a perspective view illustrating a method for manufacturing a semiconductor device in which a pre-active region layer 322 is formed over the first gate 290 and the bit line 250.

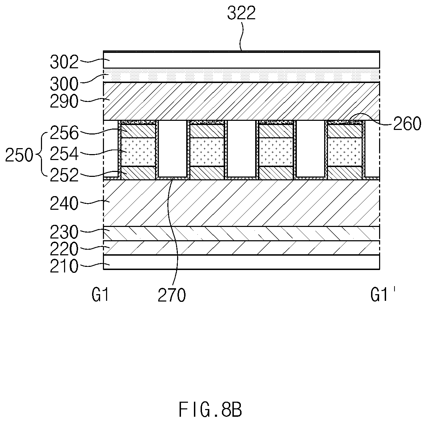

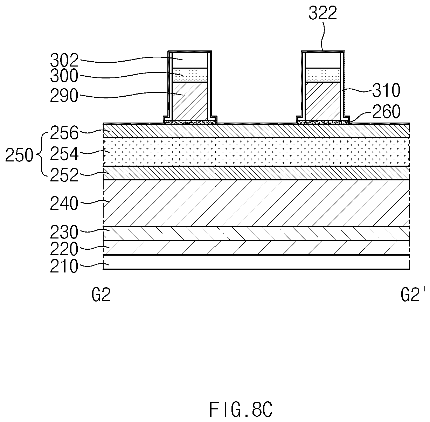

FIG. 8B is a cross-sectional view illustrating the semiconductor device taken along the line G1-G1' shown in FIG. 8A, and FIG. 8C is a cross-sectional view illustrating the semiconductor device taken along the line G2-G2' shown in FIG. 8A.

Referring to FIG. 8B showing a cross-sectional view illustrating the semiconductor device taken along the center of the first gate 290 and FIG. 8C showing a cross-sectional view illustrating the semiconductor device taken along the first gates 290 adjacent to each other, a second nitride layer 300 is formed over the first gate 290, a protective oxide layer 302 may be formed over the second nitride layer 300, and a pre-active region layer 322 containing indium gallium zinc oxide (IGZO) may be formed over the protective oxide layer 302.

The pre-active region layer 322 may be formed to overlap with first gates 290 and the exposed bit lines 250.

For example, the pre-active region layer 322 may be formed of an amorphous oxide semiconductor material, and may be formed by an atomic layer deposition (ALD) method.

When the pre-active region layer 322 is formed by atomic layer deposition (ALD), the thickness of the pre-active region layer 322 may be easily adjusted, and the film quality of the pre-active layer 322 may be formed uniformly, thereby improving electrical characteristics of the semiconductor device.

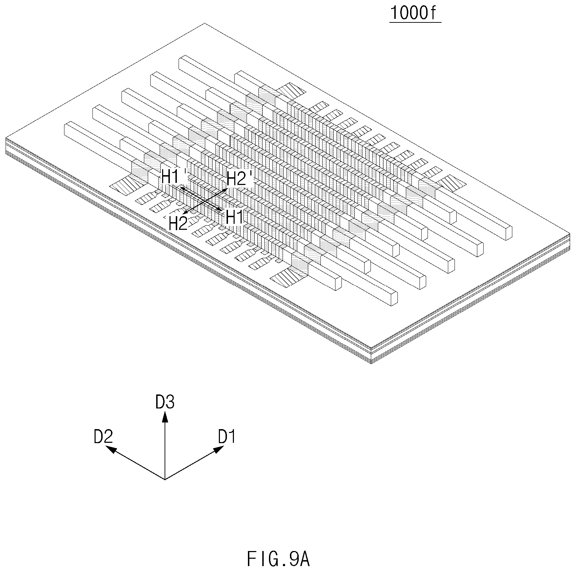

FIG. 9A is a perspective view 1000f illustrating a method for manufacturing a semiconductor device in which an active region 320 is selectively formed over the first gate 290 and the bit line 250.

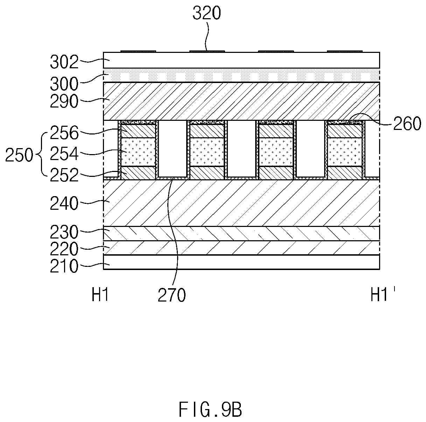

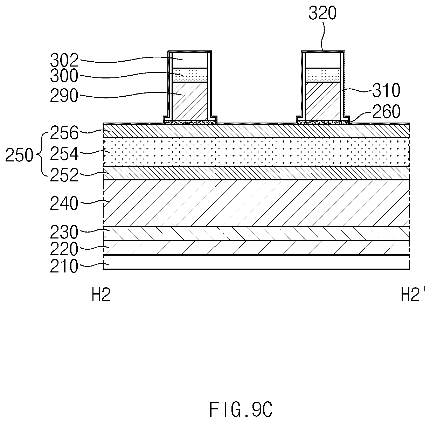

FIG. 9B is a cross-sectional view illustrating the semiconductor device taken along the line H1-H1' shown in FIG. 9A, and FIG. 9C is a cross-sectional view illustrating the semiconductor device taken along the line H2-H2' shown in FIG. 9A.

Referring to FIG. 9B showing a cross-sectional view illustrating the semiconductor device taken along the center of the first gate 290 and FIG. 9C showing a cross-sectional view illustrating the semiconductor device taken along the first gates 290 adjacent to each other, each of the active regions 320 may be arranged along the first gate oxide layer 310 that includes a horizontal portion formed to contact the bit line 250 and a vertical portion arranged along the sidewall of the first gate 290.

The adjacent active regions 320 may be preferentially isolated from each other in the second direction (D2) in which the first gate 290 extends. After the second gates 340 are formed, the second gates 340 are then etched so that the second gates 340 may be isolated from each other in the first direction (D1).

The width of the active region 320 viewed from the first direction (D1) may be equal to or less than the width of the bit line 250 viewed from the first direction (D1).

A mask containing a Spin on Carbon (SoC) layer and a silicon oxynitride (SiON) layer may be formed over the pre-active region layer 322, and the pre-active region layer 322 may be selectively etched, so that the active region 320 may be selectively formed in some regions.

In some embodiments, formation of the active region 320 may be performed using two masks with different etching properties.

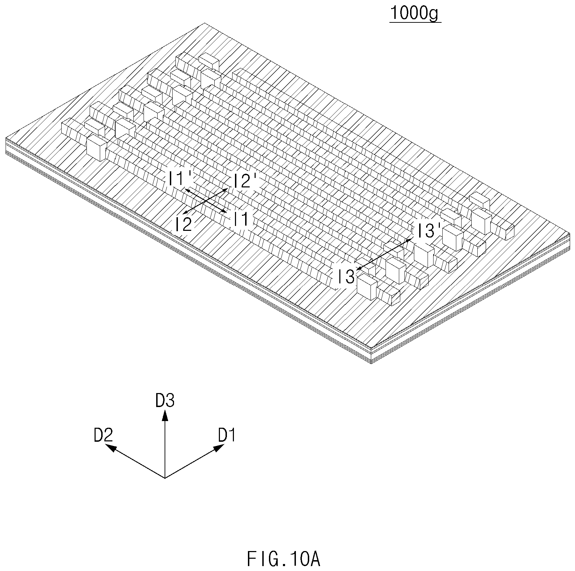

FIG. 10A is a perspective view 1000g illustrating a method for manufacturing a semiconductor device in which a second gate oxide layer 330, a pre-second gate layer 342, and a contact mask 344 are formed.

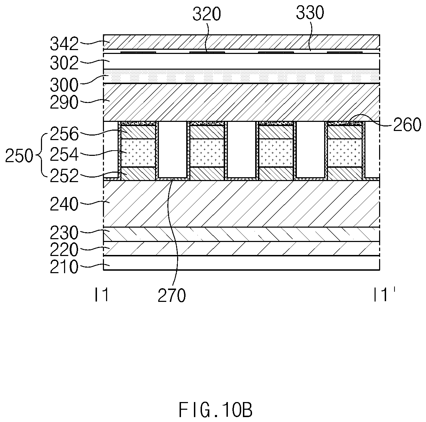

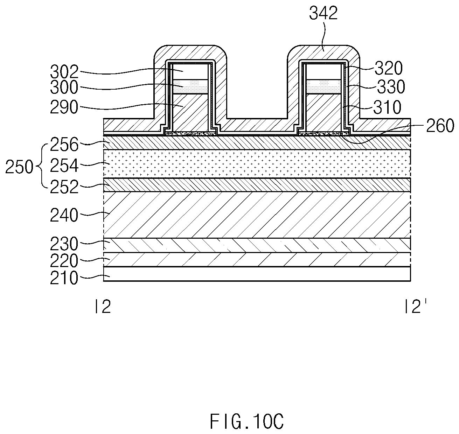

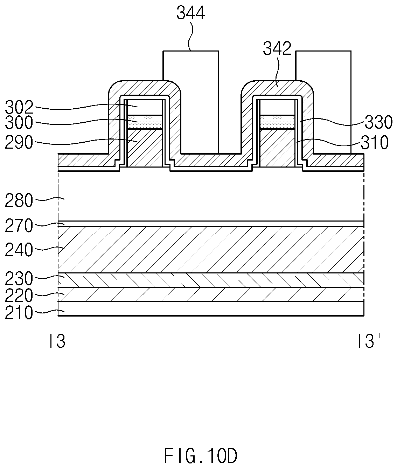

FIG. 10B is a cross-sectional view illustrating the semiconductor device taken along the line I1-I1' shown in FIG. 10A, FIG. 10C is a cross-sectional view illustrating the semiconductor device taken along the line I2-I2' shown in FIG. 10A, and FIG. 10D is a cross-sectional view illustrating the semiconductor device taken along the line 13-13' shown in FIG. 10A.

Referring to FIG. 10B which shows a cross-sectional view illustrating the semiconductor device taken along the center of the first gate 290 and FIG. 10C which shows a cross-sectional view illustrating the semiconductor device taken along the first gates 290 adjacent to each other, a second gate oxide layer 330 by which the active region 320 and the pre-second gate layer 342 are electrically isolated from each other may be disposed over the active region 320.

A second gate 340 may be formed by etching the pre-second gate layer 342.

FIG. 10D is a cross-sectional view illustrating a region corresponding to the second region (R2) shown in FIG. 2A during the semiconductor fabrication process.

Referring to FIG. 10D, a contact mask 344 may be used to form a contact portion 346 of the second gate 340 by selectively etching the pre-second gate layer 342. A contact portion 346 for connecting the second gate 340 to the conductive line may be formed by preventing etching of the pre-second gate layer 342 formed to overlap with contact mask 344.

The active region 320 is not formed in the second region (R2). The bit line 250 and the first bit-line isolation layer 260 are not formed in the second region (R2), so that the first gate 290 and the first gate oxide layer 310 may be disposed over the third bit-line isolation layer 280.

In some embodiments, the contact mask 344 may contain Spin on Carbon (SoC) materials, and the SoC-doped layer may be etched so that only the contact mask 344 remains.

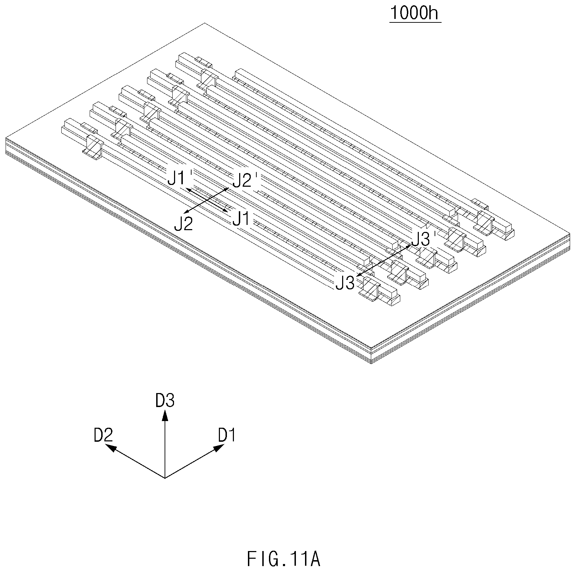

FIG. 11A is a perspective view 1000h illustrating a method for manufacturing a semiconductor device in which the second gate layer 340 and the contact portion 346 are formed.

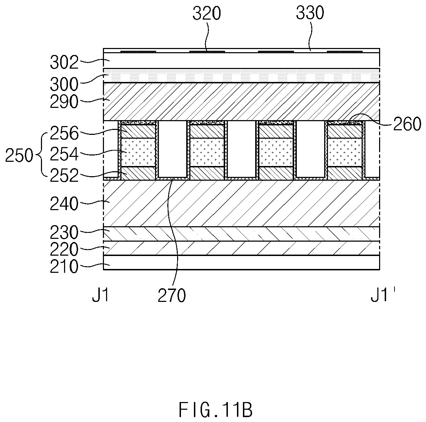

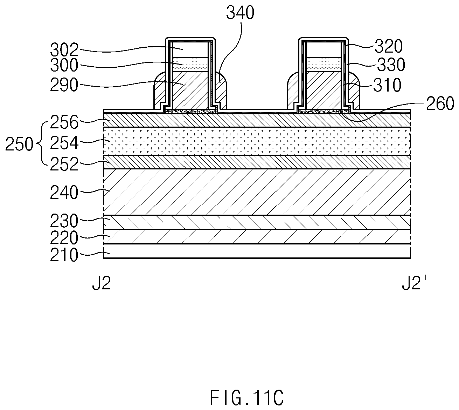

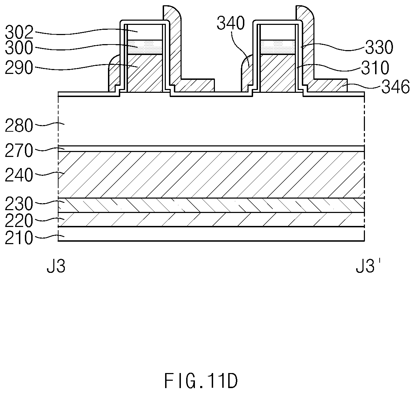

FIG. 11B is a cross-sectional view illustrating the semiconductor device taken along the line J1-J1' shown in FIG. 11A, FIG. 11C is a cross-sectional view illustrating the semiconductor device taken along the line J2-J2' shown in FIG. 11A, and FIG. 11D is a cross-sectional view illustrating the semiconductor device taken along the line J3-J3' shown in FIG. 11A.

Referring to FIG. 11B which shows a cross-sectional view illustrating the semiconductor device taken along the center of the first gate 290 and FIG. 11C which shows a cross-sectional view illustrating the semiconductor device taken along the first gates 290 adjacent to each other, the second gate 340 may be formed by selectively etching the pre-second gate layer 342.

The second gate 340 may contain titanium nitride (TiN), and only the second gate 340 may be selectively etched using a difference in etch rate between the titanium nitride (TiN) layer and the second gate oxide layer 330. Adjacent second gates 340 may be physically/electrically isolated from each other through the etching process.

FIG. 11D is a cross-sectional view illustrating a contact portion 346 formed at one side of the second gate 340. Referring to FIG. 11D, the contact portion 346 may be physically isolated from the other adjacent second gate 340 through the etching process, and may include a margin region that has a greater width than the second gate 340 to facilitate connection with the conductive line.

The contact mask 344 may be removed after selective etching of the contact portion 346.

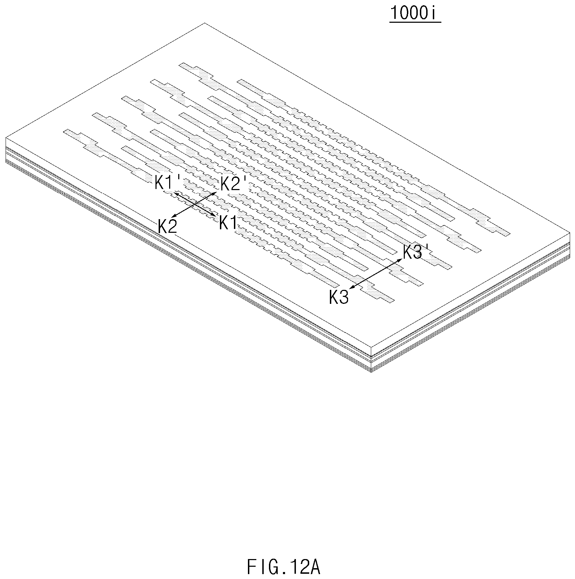

FIG. 12A is a perspective view 1000i illustrating a method for manufacturing a semiconductor device in which a third nitride layer 350 and a second oxide layer 360 are formed.

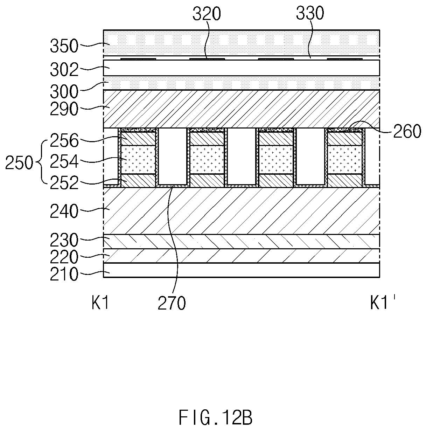

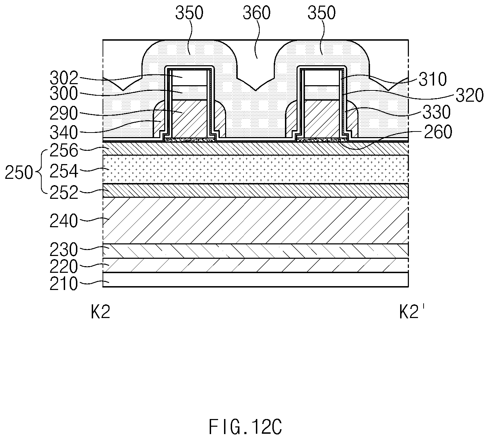

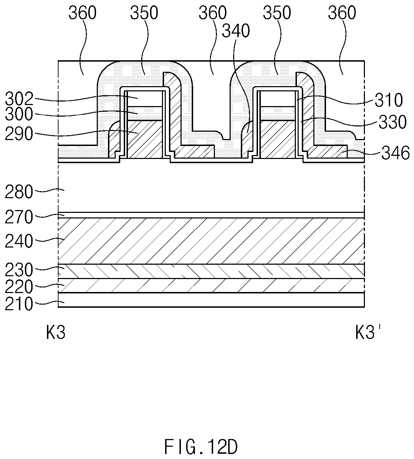

FIG. 12B is a cross-sectional view illustrating the semiconductor device taken along the line K1-K1' shown in FIG. 12A, FIG. 12C is a cross-sectional view illustrating the semiconductor device taken along the line K2-K2' shown in FIG. 12A, and FIG. 12D is a cross-sectional view illustrating the semiconductor device taken along the line K3-K3' shown in FIG. 12A.

Referring to FIG. 12B showing a cross-sectional view illustrating the semiconductor device taken along the center of the first gate 290 and FIG. 12C showing a cross-sectional view illustrating the semiconductor device taken along the first gates 290 adjacent to each other, a third nitride layer 350 may be formed to surround adjacent second gates and the second gate oxide layer 330, and the second oxide layer 360 may be formed over the third nitride layer 350.

Since the silicon nitride layer and the silicon oxide layer are sequentially deposited and a CMP (chemical mechanical polishing) process is then performed on the resultant structure, the third nitride layer 350 and the second oxide layer 360 may have the shapes shown in FIGS. 12A to 12C.

FIG. 12D is a cross-sectional view illustrating a third nitride layer 350 and a second oxide layer 360 that are formed at the side of the contact portion 346. As the contact portion 346 is disposed, the doping shape of silicon nitride may be different from that of FIG. 12C.

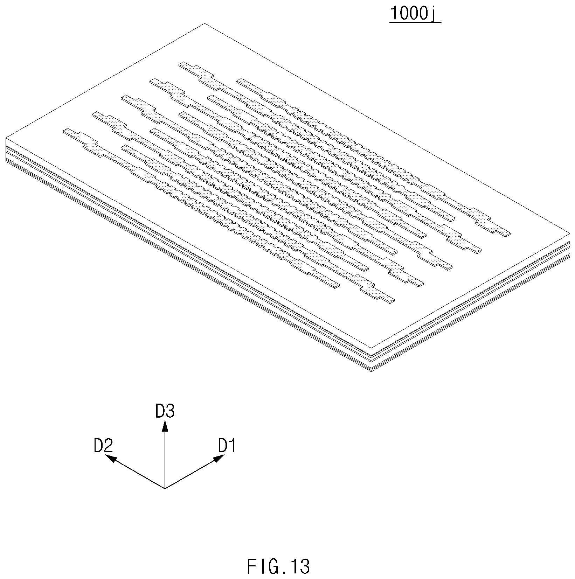

A process for isolating the adjacent second gates 340 from each other in the second region R2 shown in FIG. 2A will hereinafter be described with reference to FIGS. 13 to 15.

As illustrated in FIG. 11A, two adjacent second gates 340 may be formed to contact each other in the second region (R2) while surrounding one end of the first gate 290 adjacent to the second gates 340.

In order for each of the second gates 340 to be driven as a word line, the two adjacent second gates 340 should be electrically isolated from each other. Isolating adjacent second gates 340 from each other in the second region R2 allows the second gates 340 to operate individually.

FIG. 13 is a perspective view 1000j illustrating a method for manufacturing a semiconductor device in which a portion of the second oxide layer 360 is etched.

Referring to FIG. 13, a portion of the second oxide layer 360 may be removed through wet etching so that one end of the second gate 340 may be easily separated.

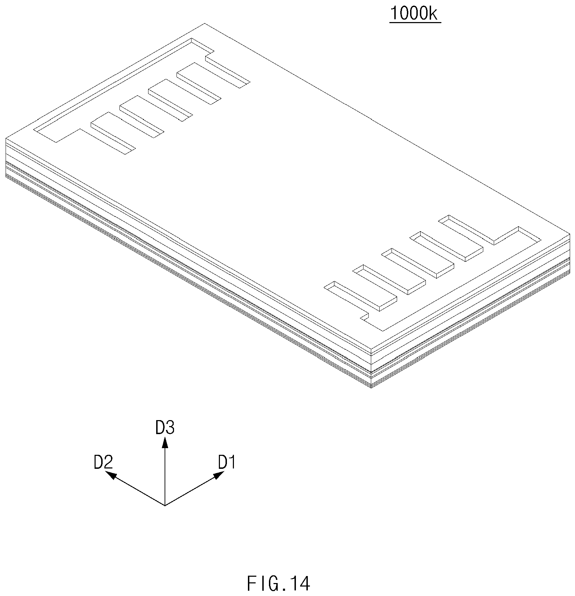

FIG. 14 is a perspective view 1000k illustrating a method for manufacturing a semiconductor device in which a mask is formed over the etched second oxide layer 360.

A mask is formed and both ends of the second gate 340 are selectively etched using the mask, so that adjacent second gates 340 may be isolated from each other.

The mask may include the SOC layer and the SiON layer. A region in which one end of the second gate 340 is separated may be defined using the mask.

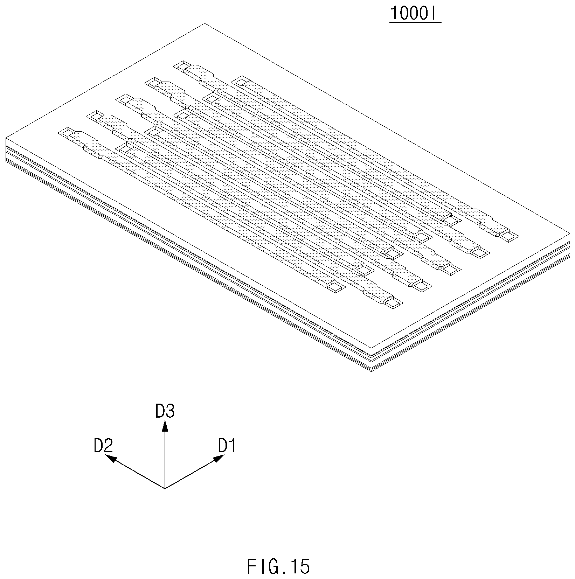

FIG. 15 is a perspective view 1000l illustrating a method for manufacturing a semiconductor device in which a mask is removed after selectively etching both ends of the second gate 340.

Referring to FIG. 15, one end of the second gate 340 is separated and the third nitride layer 350 of the corresponding region is etched, so that the adjacent second gates 340 may be electrically isolated from each other.

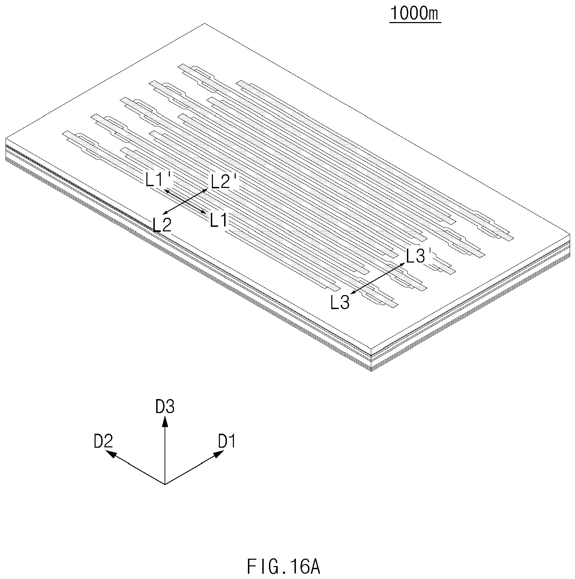

FIG. 16A is a perspective view 1000m illustrating a method for manufacturing a semiconductor device in which adjacent active regions 320 are isolated from each other in the first direction (D1).

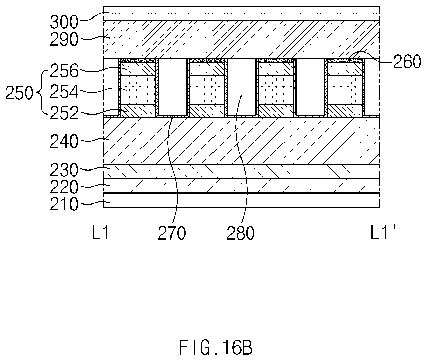

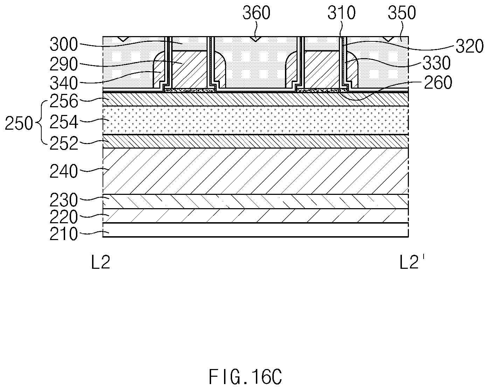

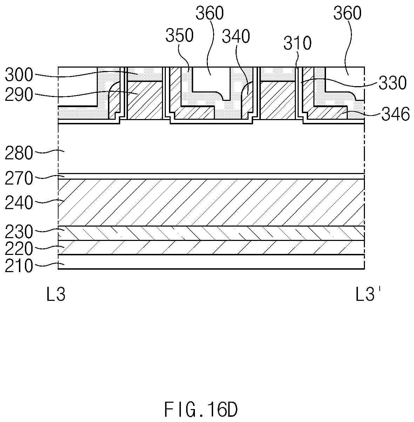

FIG. 16B is a cross-sectional view illustrating the semiconductor device taken along the line L1-L1' shown in FIG. 16A, FIG. 16C is a cross-sectional view illustrating the semiconductor device taken along the line L2-L2' shown in FIG. 16A, and FIG. 16D is a cross-sectional view illustrating the semiconductor device taken along the line L3-L3' shown in FIG. 16A.

Referring to FIG. 16B which shows a cross-sectional view illustrating the semiconductor device taken along the center of the first gate 290 and FIG. 16C which shows a cross-sectional view illustrating the semiconductor device taken along the first gates 290 adjacent to each other. A portion of the third nitride layer 350, a portion of the second gate oxide layer 330, a portion of the active region 320, a portion of the first gate oxide layer 310, and the protective oxide layer 302 may be removed by the etching or CMP (chemical mechanical polishing) process.

Referring to FIG. 16D, similar to FIG. 16C, a portion of the third nitride layer 350, a portion of the second gate oxide layer 330, a portion of the first gate oxide layer 310, and the protective oxide layer 302(not shown) may be removed by the etching process, and at least a portion of the contact portion 346 may be exposed.

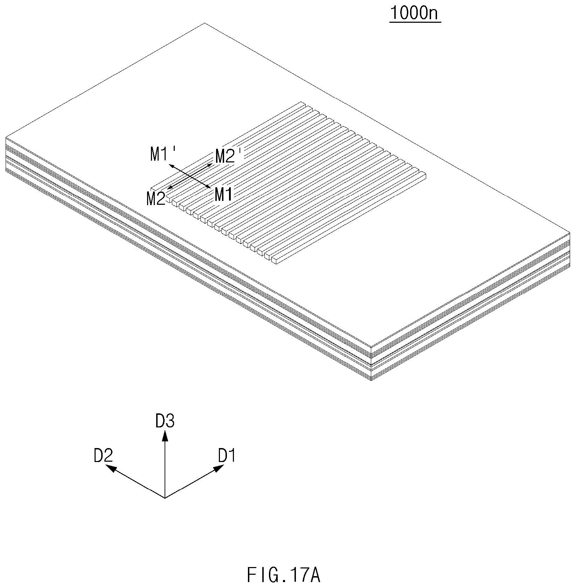

FIG. 17A is a perspective view illustrating a method for manufacturing a semiconductor device in which a contact pad contacting one end of a vertical portion included in the active region 320 is formed.

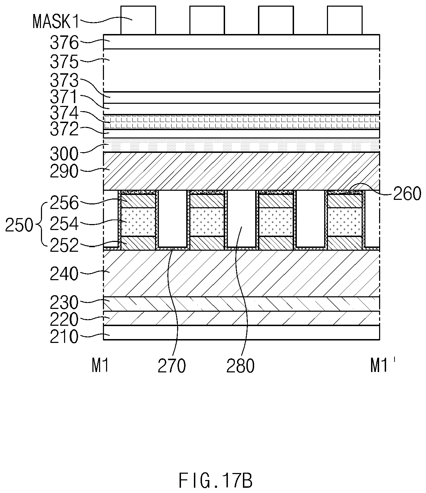

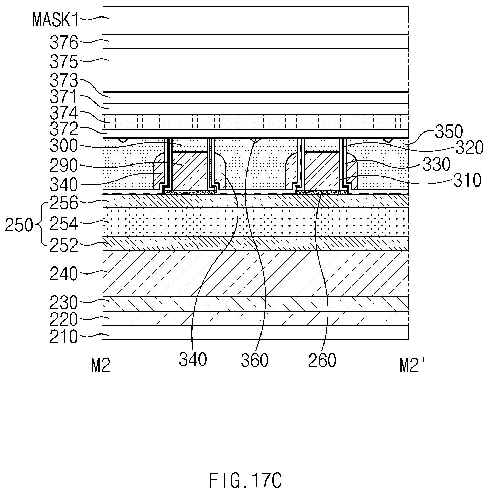

FIG. 17B is a cross-sectional view illustrating the semiconductor device taken along the line M1-M1' shown in FIG. 17A, and FIG. 17C is a cross-sectional view illustrating the semiconductor device taken along the line M2-M2' shown in FIG. 17A.

Referring to FIG. 17B which shows a cross-sectional view illustrating the semiconductor device taken along the center of the first gate 290 and FIG. 17C which shows a cross-sectional view illustrating the semiconductor device taken along the first gates 290 adjacent to each other, a first pad layer 372, a second pad layer 374, a first hard mask layer 371, and a second hard mask layer 373 may be sequentially formed over the second nitride layer 300. Here, the first pad layer 372 has the same material as the active region 320 and is connected to the active region 320. The second pad layer 374 is disposed over the first pad layer 372 and contains a conductive material. The first hard mask layer 371 is disposed over the second pad layer 374, and includes a hard mask for etching the first pad layer 372 and the second pad layer 374. The second hard mask layer 373 is disposed over the first hard mask layer 371, and includes a hard mask for etching the first pad layer 372 and the second pad layer 374.

The first hard mask layer 371 may be a silicon nitride layer, and the second hard mask layer 372 may be a silicon oxide layer.

Additionally, a first SoC (Spin on Carbon) layer 375, a first SiON layer 376, and a first mask (MASK1) may be sequentially disposed over the second hard mask layer 373. The first mask (MASK1) may comprise of a plurality of line shaped masks extending in the first direction (D1) consecutively arranged in the second direction (D2) at a regular interval. First mask (MASK1) may be disposed to overlap with an area where the contact pad 370 (372, 374) is formed.

More specifically, the first mask (MASK1) may be arranged so that the contact pad 370 is formed in a region where the bit line 250 and the vertical portion of the active region 320 overlap each other.

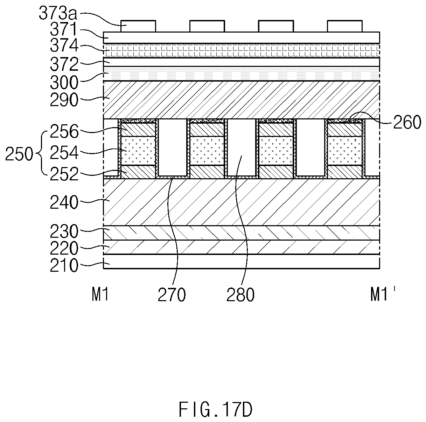

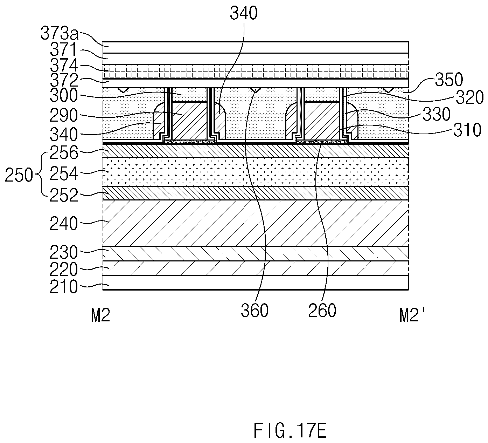

FIG. 17D is a cross-sectional view illustrating the semiconductor taken along the line M1-M1' shown in FIG. 17A after etching the second hard mask layer 373, and FIG. 17E is a cross-sectional view illustrating the semiconductor device taken along the line M2-M2' shown in FIG. 17A after etching the second hard mask layer 373.

Referring to FIGS. 17D and 17E, the second hard mask layer 373 may be etched to form a plurality of primary hard masks 373a, each of which is etched to extend in the first direction (D1) and is repeatedly disposed in the second direction (D2).

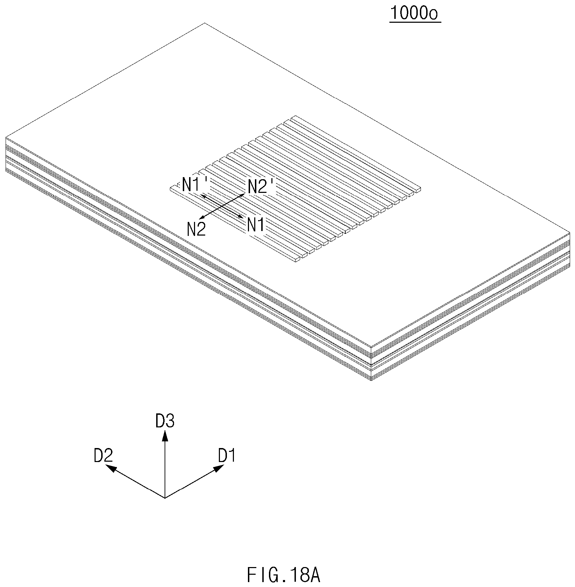

FIG. 18A is a perspective view 1000o illustrating a method for manufacturing a semiconductor device in which a contact pad contacting one end of a vertical portion included in an active region is formed.

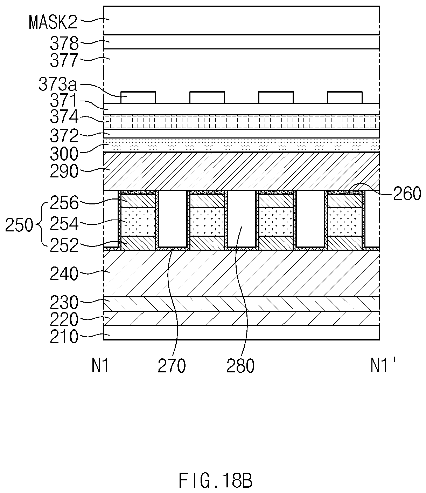

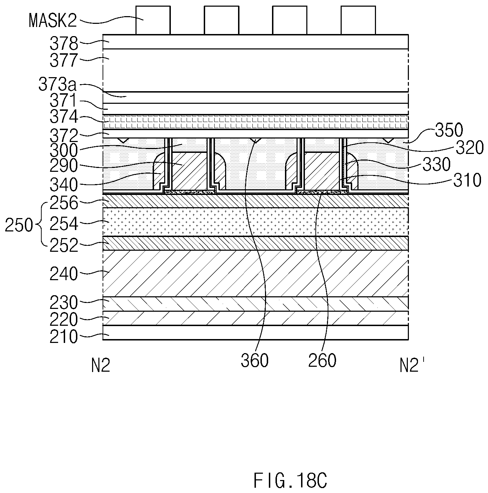

FIG. 18B is a cross-sectional view illustrating a semiconductor device taken along the line N1-N1' shown in FIG. 18A, and FIG. 18C is a cross-sectional view illustrating a semiconductor device taken along the line N2-N2' shown in FIG. 18A.

Referring to FIG. 18B which shows a cross-sectional view illustrating the semiconductor device taken along the center of the first gate 290 and FIG. 18C which shows a cross-sectional view illustrating the semiconductor device taken along the first gates 290 adjacent to each other, a second SoC layer 377, a second SiON layer 378, and a second mask (MASK2) may be sequentially disposed over the primary hard masks 373a formed from the second hard mask layer 373.

The second mask (MASK2) may extend in a direction (D2) perpendicular to the first mask (MASK1). The second mask (MASK2) may include a plurality of masks repeatedly arranged in the first direction (D1) at a regular interval. Since the primary hard mask 373a is etched using the second mask (MASK2), hard masks repeatedly arranged in a matrix structure may be formed.

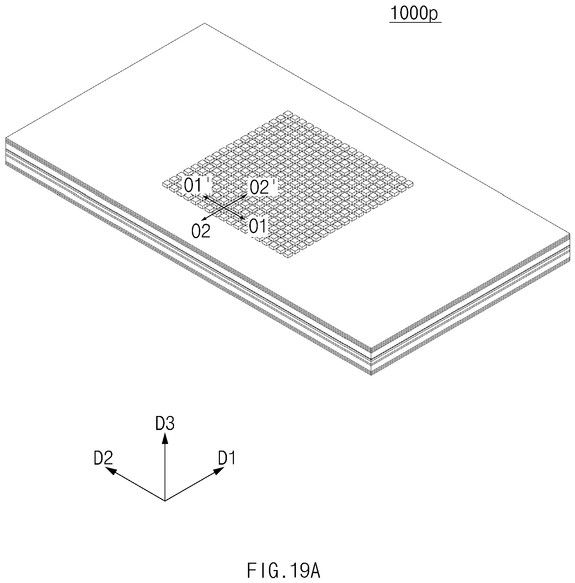

FIG. 19A is a perspective view 1000P illustrating a method for manufacturing a semiconductor device in which a contact pad contacting one end of a vertical portion included in the active region 320 is formed.

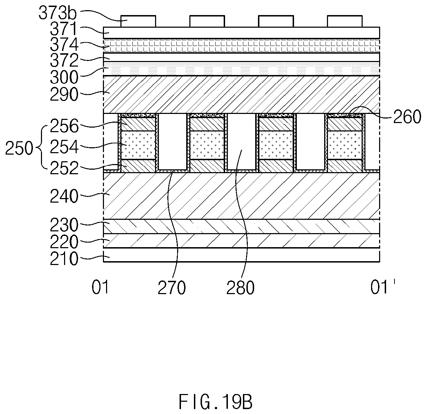

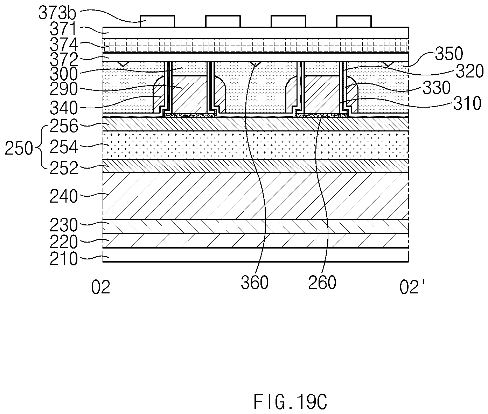

FIG. 19B is a cross-sectional view illustrating a semiconductor device taken along the line O1-O1' shown in FIG. 19A, and FIG. 19C is a cross-sectional view illustrating a semiconductor device taken along the line O2-O2' shown in FIG. 19A.

Referring to FIG. 19B, at least one secondary hard mask 373b formed through two etching processes may have the same width in the first direction (D1) and the second direction (D2), and may be arranged to have a layout structure in which the secondary hard masks 373b are repeatedly arranged in a matrix shape.

The layout structure of the contact pad may vary depending on the shape of the secondary hard masks 373b. In addition, the shape of the secondary hard mask 373b may vary depending on the number of storage elements (e.g., capacitors) provided in the semiconductor device.

Referring to FIG. 19B which shows a cross-sectional view illustrating the semiconductor device taken along the center of the first gate 290 and FIG. 19C which shows a cross-sectional view illustrating the semiconductor device taken along the first gates 290 adjacent to each other, a cross-sectional view of the secondary hard masks 373b for forming the contact pad 370 is shown. The secondary hard masks 373b may be repeatedly arranged in a matrix structure, and may be formed to overlap one end of the vertical portion of the active region 320.

Thereafter, the first pad layer 372 and the second pad layer 374 are selectively etched using the secondary hard mask 373b, so that the contact pads 370 that are arranged in a matrix structure while contacting one end of the vertical portion of the active region 320 may be formed.

In some embodiments, an additional insulation layer pattern may be formed over the secondary hard masks 373b, and the first pad layer 372 and the second pad layer 374 may be selectively etched using the insulation layer pattern and the secondary hard masks 373b.

The additional insulating layer pattern may include Ultra Low Temperature Oxide (ULTO).

As the contact pads 370 are formed using the additional insulation layer pattern and the secondary hard masks 373b, each of the contact pads 370 may have a larger area than the secondary hard masks 373b.

After the contact pads 370 are etched, a fourth nitride layer 380 may be formed between the contact pads 370 to electrically isolate the adjacent contact pads 370 from each other. The fourth nitride layer 380 may be formed to have a shape surrounding the contact pads 370 as shown in FIGS. 2C, 2D.

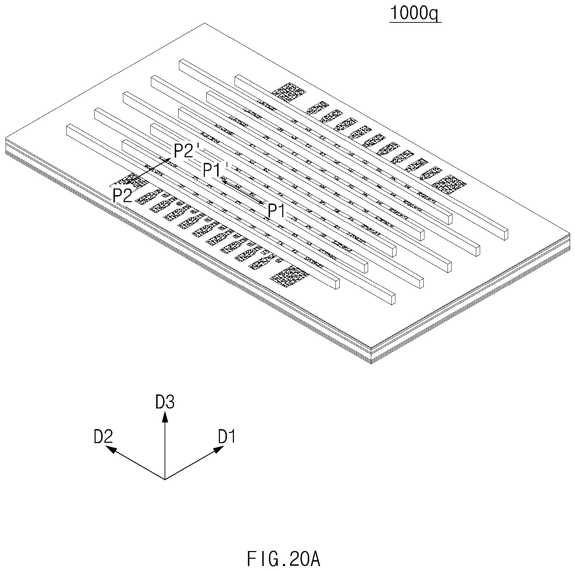

FIGS. 20A to 26C are views illustrating a method for manufacturing a semiconductor device according to another embodiment of the present disclosure.

FIG. 20A is a perspective view 1000q illustrating a method for manufacturing a semiconductor device in which an isolation oxide layer 592 is formed over a first bit-line isolation layer 560, a second bit-line isolation layer 570, and a third bit-line isolation layer 580.

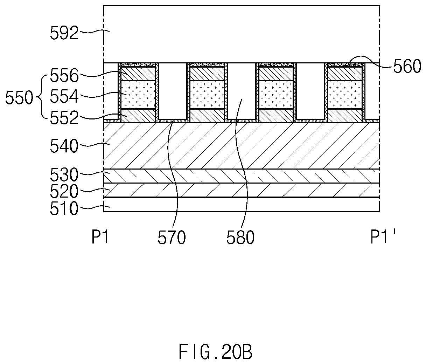

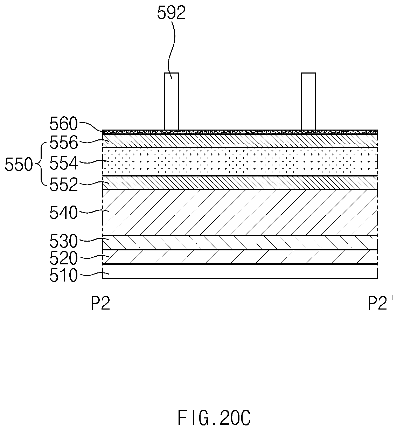

FIG. 20B is a cross-sectional view illustrating a semiconductor device taken along the line P1-P1' shown in FIG. 20A, and FIG. 20C is a cross-sectional view illustrating a semiconductor device taken along the line P2-P2' shown in FIG. 20A.

Referring to FIG. 20B which shows a cross-sectional view illustrating the semiconductor device taken along the plurality of bit lines 550 and FIG. 20C which shows a cross-sectional view illustrating the semiconductor device taken along the center of the bit lines 550, an isolation oxide layer 592 may extend in the direction (D2) perpendicular to the first direction (D1) in which the bit lines 550 extend.

The isolation oxide layer 592 may include silicon oxide, and may be formed by etching the oxide layer that is formed over the first bit-line isolation layer 560, the second bit-line isolation layer 570, and the third bit-line isolation layer 580.

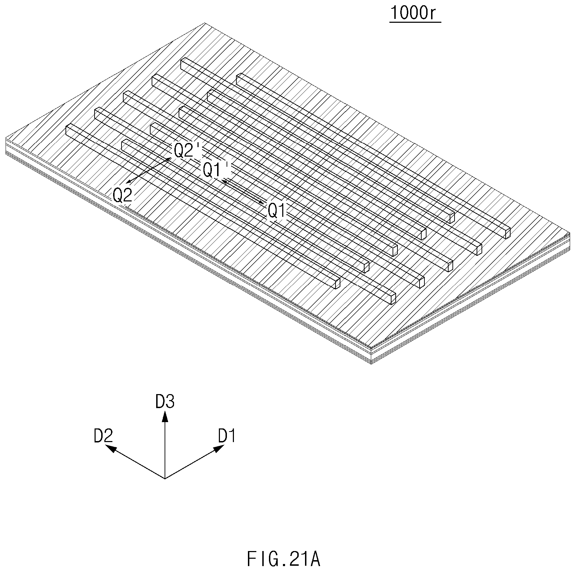

FIG. 21A is a perspective view 1000r illustrating a method for manufacturing a semiconductor device in which a pre-first gate layer 594 is formed over the isolation oxide layer 592.

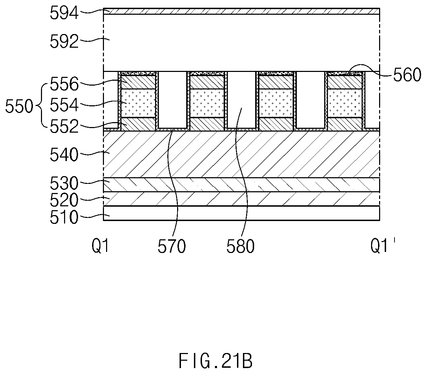

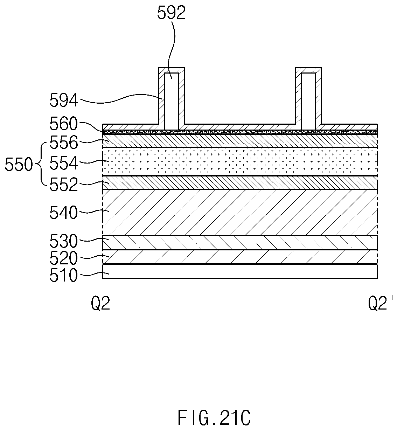

FIG. 21B is a cross-sectional view illustrating a semiconductor device taken along the line Q1-Q1' shown in FIG. 21A, and FIG. 21C is a cross-sectional view illustrating a semiconductor device taken along the line Q2-Q2' shown in FIG. 21A.

Referring to FIG. 21B which shows a cross-sectional view illustrating the semiconductor device taken along the center of the isolation oxide layer 592 and FIG. 21C which shows a cross-sectional view illustrating the semiconductor device taken along the center of the bit lines 550, a pre-first gate layer 594 containing a conductive material such as titanium nitride (TiN) may be formed to overlap with isolation oxide layer 592 and the first bit-line isolation layer 560.

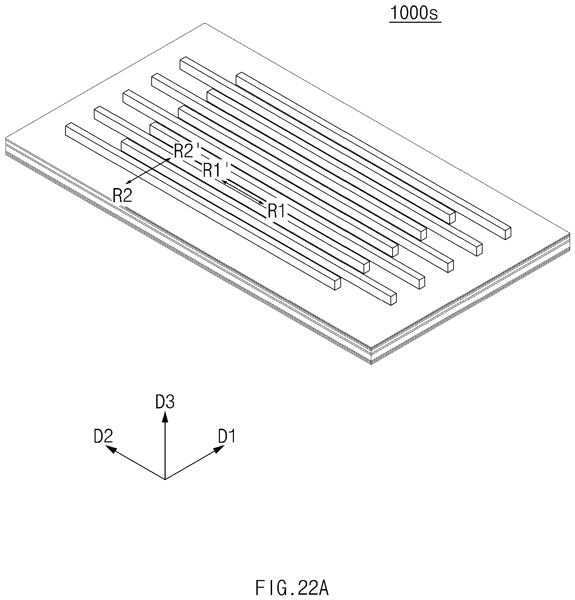

FIG. 22A is a perspective view 1000s illustrating a method for manufacturing a semiconductor device in which a first gate 590 is formed by etching a pre-first gate layer 594 and a first gate oxide layer 610 is formed over the first gate 590.

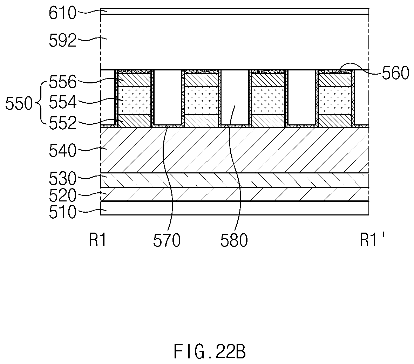

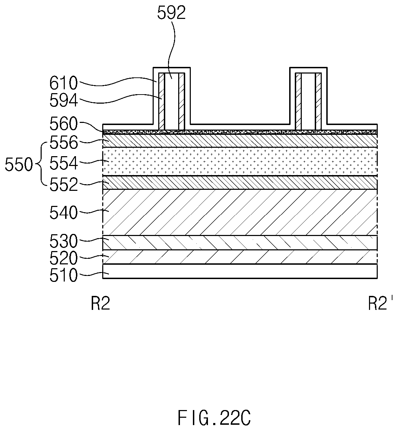

FIG. 22B is a cross-sectional view illustrating a semiconductor device taken along the line R1-R1' shown in FIG. 22A, and FIG. 22C is a cross-sectional view illustrating a semiconductor device taken along the line R2-R2' shown in FIG. 22A.

Referring to FIG. 22B which shows a cross-sectional view illustrating the semiconductor device taken along the center of the isolation oxide layer 592 and FIG. 22C which shows a cross-sectional view illustrating the semiconductor device taken along the center of the bit lines 550, a first gate 590 (SEE FIGS. 3C AND 3D) may be formed to extend along the sidewall of the isolation oxide layer 592 through the etching process, and a first gate oxide layer 610 may be formed to overlap with first gates 590.

The first gate oxide layer 610 may include silicon oxide, and may be arranged to surround the first gates 590 and the isolation oxide layer 592 disposed between the first gates 590.

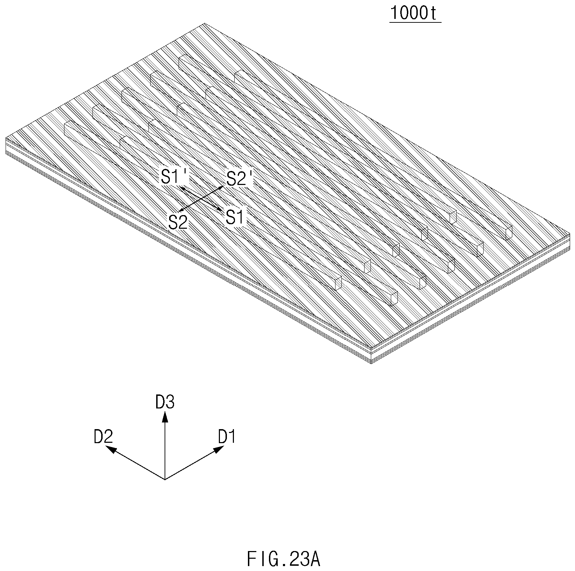

FIG. 23A is a perspective view illustrating a method for manufacturing a semiconductor device in which a protective silicon layer 612 is formed over a first gate oxide layer 610.

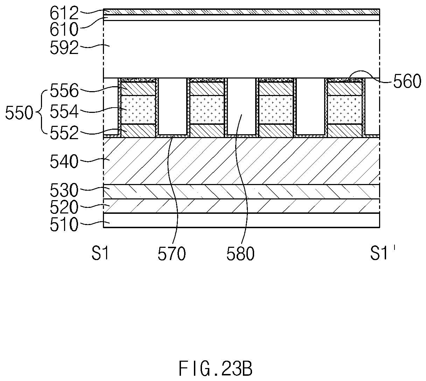

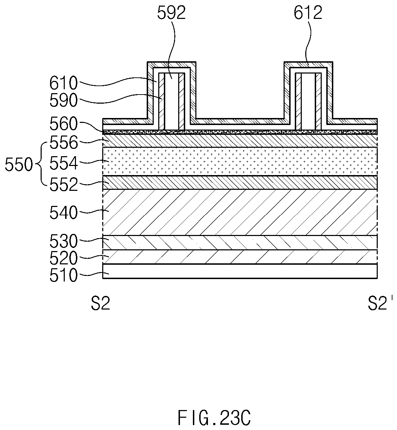

FIG. 23B is a cross-sectional view illustrating a semiconductor device taken along the line S1-S1' shown in FIG. 23A, and FIG. 23C is a cross-sectional view illustrating a semiconductor device taken along the line S2-S2' shown in FIG. 23A.

Referring to FIG. 23B which shows a cross-sectional view illustrating the semiconductor device taken along the center of the isolation oxide layer 592 and FIG. 23C which shows a cross-sectional view illustrating the semiconductor device taken along the center of the bit lines 550, a protective silicon layer 612 may be formed over the first gate oxide layer 610.

The protective silicon layer 612 may protect the first gate oxide layer 610 located below the protective silicon layer 612 during the etching process.

The protective silicon layer 612 may be a layer containing polysilicon. As the protective silicon layer 612 is provided in the semiconductor device, the first bit-line isolation layer 560 disposed over the bit lines 550 may be etched to form the active region 320 that contacts at least a portion of the bit line 550. At this time, damage to the first gate oxide layer 610 may be prevented.

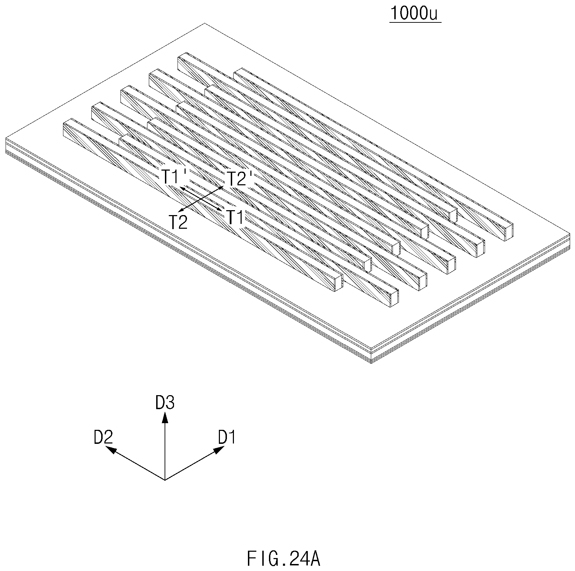

FIG. 24A is a perspective view 1000u illustrating a method for manufacturing a semiconductor device in which at least a portion of a protective silicon layer 612, at least a portion of a first gate oxide layer 610, and at least a portion of a first bit-line isolation layer 560 are etched.

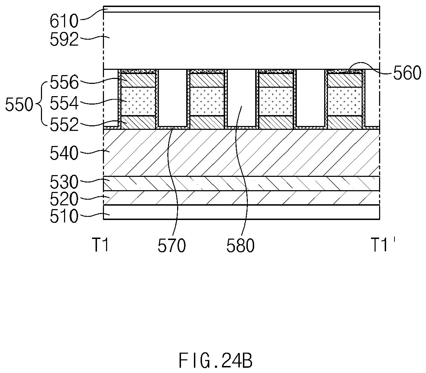

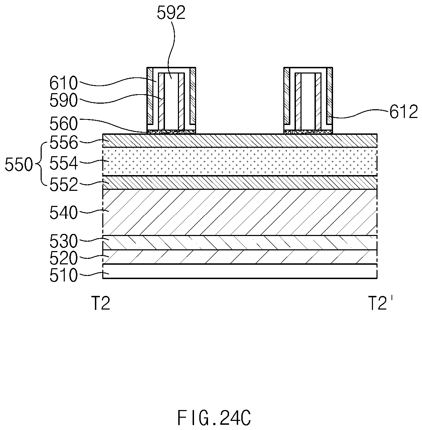

FIG. 24B is a cross-sectional view illustrating a semiconductor device taken along the line T1-T1' shown in FIG. 24A, and FIG. 24C is a cross-sectional view illustrating a semiconductor device taken along the line T2-T2' shown in FIG. 24A.

Referring to FIG. 24B which shows a cross-sectional view illustrating the semiconductor device taken along the center of the isolation oxide layer 592 and FIG. 24C which shows a cross-sectional view illustrating the semiconductor device taken along the center of the bit lines 550, after completion of the plasma etching process, the first gate oxide layer 610 may be disposed along the sidewall of the first gate 590 and the first bit-line isolation layer 560 disposed below the first gate 590, and the protective silicon layer 612 may remain on the first gate oxide layer 610 along the sidewall of the first gate 590.

The first gate oxide layer 610 disposed between the protective silicon layer 612 and the first gate 590 may be protected from plasma by the remaining protective silicon layer 612. Thereafter, the remaining protective silicon layer 612 may be selectively removed through a separate silicon etching process. The silicon etching process may include, for example, a wet etching process.

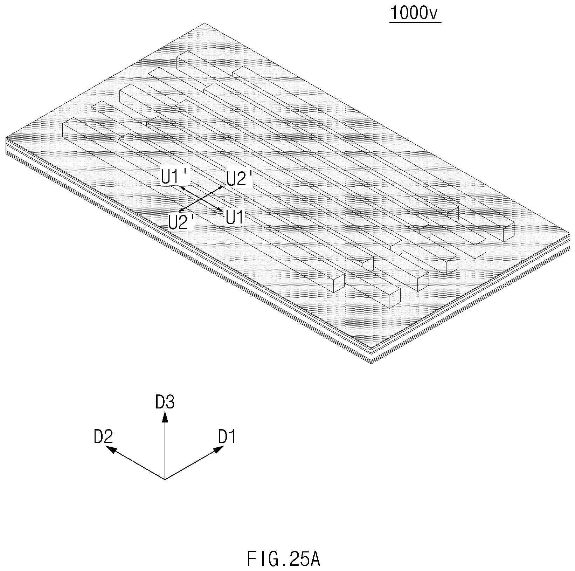

FIG. 25A is a perspective view 1000v illustrating a method for manufacturing a semiconductor device in which a pre-active region layer 622 is formed over the first gate oxide layer 610 and the bit line 550.

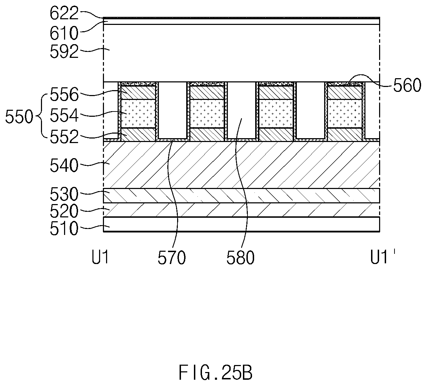

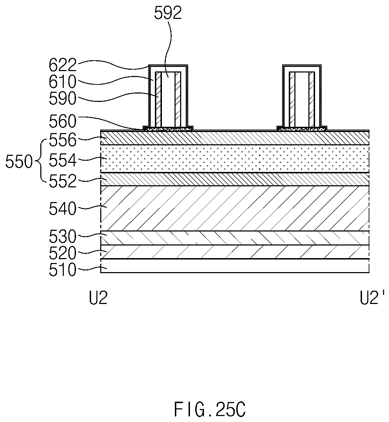

FIG. 25B is a cross-sectional view illustrating a semiconductor device taken along the line U1-U1' shown in FIG. 25A, and FIG. 25C is a cross-sectional view illustrating a semiconductor device taken along the line U2-U2' of FIG. 25A.

Referring to FIG. 25B which shows a cross-sectional view illustrating the semiconductor device taken along the center of the isolation oxide layer 592 and FIG. 25C which shows a cross-sectional view illustrating the semiconductor device taken along the center of the bit line 550, a first gate oxide layer 610 may be formed over the first gate 590 and the isolation oxide layer 592.

A pre-active region layer 622 containing indium gallium zinc oxide (IGZO) may be formed over the first gate oxide layer 610. The pre-active region layer 622 may be formed to overlap with exposed bit line 550.

For example, the pre-active region layer 622 may be formed of an amorphous oxide semiconductor. The pre-active region layer 622 may be formed by atomic layer deposition (ALD).

When the pre-active region layer 622 is formed by atomic layer deposition (ALD), the thickness of the pre-active region layer 622 may be easily adjusted, and the film quality of the pre-active region layer 622 may be formed uniformly, thereby improving the electrical characteristics of the semiconductor device.

The subsequent manufacturing process of the semiconductor device according to another embodiment of the present disclosure may be substantially the same as the processes described above through FIGS. 9A to 19C.

An active region 620 may be formed by selectively etching the first gate 590, the isolation oxide layer 592, and the pre-active region layer 622 formed over the first gate oxide layer 610, and a second gate oxide layer 630 and at least one second gate 640 may be formed over the active region 620.

In addition, a third nitride layer 650 that electrically isolates the second gates 640 from each other may be formed between the second gates 640, and a contact pad contacting one side of the vertical portion included in the active region 620 may be formed.

As is apparent from the above description, the semiconductor device based on some embodiments of the present disclosure includes three-dimensional (3D) channels to improve the degree of integration.

Additionally, the semiconductor device based on some embodiments of the present disclosure includes a plurality of gates, so that the degree of integration may be improved and interference between adjacent gates may be minimized.

The embodiments of the present disclosure may provide a variety of advantageous effects capable of being directly or indirectly recognized.

Those skilled in the art will appreciate that the embodiments of the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments may be devised based on what is described and/or illustrated in the present disclosure. Furthermore, the embodiments may be combined to form additional embodiments.

## Claims

1. A semiconductor device comprising:
a bit line extending in a first direction;
a first gate extending in a second direction perpendicular to the first direction;
an active region including a horizontal portion that contacts the bit line and a vertical portion that contacts the horizontal portion and extends in a third direction perpendicular to each of the first direction and the second direction; and
a second gate overlapping with at least a portion of the horizontal portion while extending in the second direction,
wherein
the vertical portion of the active region is disposed between the first gate and the second gate.

2. The semiconductor device according to claim 1, wherein
the first gate is configured not to overlap with the horizontal portion.

3. The semiconductor device according to claim 1, further comprising:
a contact pad in contact with the vertical portion of the active region and spaced apart from the horizontal portion in the third direction.

4. The semiconductor device according to claim 3, wherein
the contact pad is configured to connect a capacitive element and the vertical portion of the active region to each other.

5. The semiconductor device according to claim 3, wherein
the contact pad is configured to have a greater width than the vertical portion of the active region.

6. The semiconductor device according to claim 4, wherein
the capacitive element is a capacitor.

7. The semiconductor device according to claim 4, wherein
the contact pad includes a plurality of layers, and
wherein
a layer contacting the vertical portion from among the plurality of layers includes an oxide semiconductor material.

8. The semiconductor device according to claim 7, wherein
the contact pad includes a plurality of layers, and
wherein
a layer contacting the capacitive element from among the plurality of layers includes metal or metal nitride.

9. The semiconductor device according to claim 1, wherein
the active region includes an oxide semiconductor material.

10. The semiconductor device according to claim 9, wherein
the oxide semiconductor material includes indium gallium zinc oxide (IGZO).

11. The semiconductor device according to claim 1, wherein
the first gate is configured to receive a control signal different from that of the second gate.

12. The semiconductor device according to claim 11, wherein
one first gate is disposed between the active region and another active region adjacent to the active region.

13. The semiconductor device according to claim 1, wherein
the first gate is configured to receive the same control signal as the second gate.

14. The semiconductor device according to claim 13, wherein
one pair of the first gates is disposed between the active region and another active region adjacent to the active region.

15. The semiconductor device according to claim 1, wherein the second gate includes
at least one contact portion connected to a conductive line.

16. The semiconductor device according to claim 15, wherein
the contact portions are arranged in a zigzag pattern with respect to the first direction and are spaced apart from each other by a predetermined distance.
